# EUROPÄISCHE PATENTANMELDUNG

(11) **EP 4 020 808 A1**
(43) Veröffentlichungstag der Anmeldung: **29.06.2022**
(21) Anmeldenummer: 21216920.5
(22) Anmeldetag: 22.12.2021
(51) Int. Cl.: H03K 17/975, E05B 81/76

(54) **MULTI-SENSORMODUL, EIN GRIFFMODUL UND BEWEGLICHES FAHRZEUGELEMENT**

(30) Priorität: 22.12.2020 DE 102020216512
(71) Anmelder: Witte Automotive GmbH, 42551 Velbert (DE)
(72) Erfinder: MENSCH, Reinaldo, 42113 Wuppertal (DE); ZAMMERT, Christian, 42389 Wuppertal (DE)
(74) Vertreter: Liedtke & Partner Patentanwälte

(57) **Zusammenfassung**

Griffmodul (100), insbesondere ein Türaußengriffmodul für eine Tür, insbesondere eine bewegliche Fahrzeugtür (202) eines Fahrzeugs (200), umfassend zumindest
- ein Griffelement (100.1) mit einer Griffaußenseite (100.2) und einer Griffinnenseite (100.3) und
- einen Gestensensor (100.4) sowie einen Betätigungssensor (100.5),
wobei der Gestensensor (100.4) an oder in der Griffaußenseite (100.2) und der Betätigungssensor (100.5) an oder in der Griffinnenseite (100.3) angeordnet ist.

## Beschreibung

Die Erfindung betrifft ein Multi-Sensormodul und ein Griffmodul, insbesondere für einen Griff, wie zum Beispiel einen Außengriff für ein bewegliches Fahrzeugelement, insbesondere für eine Schiebetür, eine Heckklappe oder eine Motor-/Fronthaube, eines Fahrzeugs. Des Weiteren betrifft die Erfindung ein bewegliches Fahrzeugelement mit einem solchen Griffmodul und einem solchen Multi- Sensormodul.

Griffmodule sind beispielsweise bekannt an Fahrzeugtüren, Heckklappen oder Motorhauben. Diese sind üblicherweise mit einem Griffelement versehen, das nach außen geschwenkt werden kann, um die Fahrzeugtür, die Heckklappe oder die Motorhaube öffnen zu können. Griffmodule können dabei elektronische Multi-Sensormodule zum Öffnen eines Schlosses der Tür umfassen.

Der Erfindung liegt die Aufgabe zu Grunde, ein gegenüber dem Stand der Technik verbessertes Multi-Sensormodul anzugeben, welches kompakt aufgebaut ist und eine vereinfachte Montage ermöglicht. Des Weiteren ist ein Griffmodul mit einem solchen verbesserten Multi-Sensormodul und ein bewegliches Fahrzeugelement mit einem solchen Griffmodul anzugeben.

Die Aufgabe wird hinsichtlich des Multi-Sensormoduls erfindungsgemäß mit den im Patentanspruch 1 angegebenen Merkmalen gelöst. Hinsichtlich des Griffmoduls wird die Aufgabe erfindungsgemäß durch die im Patentanspruch 12 angegebenen Merkmale gelöst. Hinsichtlich des beweglichen Fahrzeugelements wird die Aufgabe erfindungsgemäß durch die im Patentanspruch 16 angegebenen Merkmale gelöst.

Weiterbildungen der Erfindung sind Gegenstand der abhängigen Patentansprüche.

Das erfindungsgemäße Multi-Sensormodul, insbesondere ein universelles elektronisches Multi-Sensormodul für einen Griff, wie zum Beispiel einen Türgriff, umfasst zumindest eine erste Sensoreinheit, die als ein Annäherungs- und/oder Gestensensor ausgebildet ist, eine zweite Sensoreinheit, die als ein Betätigungssensor ausgebildet ist, und eine Elektronikeinheit, die elektrisch mit den Sensoreinheiten zur Auslösung eines Signals verbunden ist, wobei der Betätigungssensor als ein zumindest bereichsweise mittels eines Schaummaterials gekapseltes und integriertes Bauteil ausgebildet und auf einer Seite der Elektronikeinheit montierbar ist und der Annäherungs- und/oder Gestensensor segmentiert ausgebildet und auf einer gegenüberliegenden Seite der Elektronikeinheit montierbar ist.

Vorzugsweise ist das Multi-Sensormodul zusätzlich zumindest bereichsweise von einem Vergussmaterial umgeben und als eine integrierte Baueinheit, insbesondere ein separates Montagemodul, ausgebildet. Zusätzlich kann das gekapselte und integrierte Bauteil des Betätigungssensors eine Vormontageeinheit bilden, die in einem Vormontagezustand auf der Elektronikeinheit montierbar ist.

Die mit der Erfindung erzielten Vorteile bestehen insbesondere darin, dass ein solches Multi-Sensormodul ausgebildet als eine integrierte Baueinheit, insbesondere als ein separates Montagemodul, variabel an einem Griff montiert werden kann. Insbesondere sind sowohl eine Elektronik der Elektronikeinheit als auch die erste und die zweite Sensoreinheit vor äußeren Umwelteinflüssen, wie Feuchtigkeit, Regen, Schmutzwasser, geschützt.

Zur einfachen Kopplung des Betätigungssensors mit der Elektronikeinheit ragen Anschlusselemente des Betätigungssensors aus dem Schaummaterial heraus und sind mit der Elektronikeinheit verbindbar oder verbunden, zum Beispiel gelötet. Eine mögliche Ausführungsform sieht vor, dass der Betätigungssensor ein bewegliches Sensorelement und ein festes Sensorelement umfasst, welches beabstandet und gegenüberliegend zu dem beweglichen Sensorelement angeordnet ist, wobei zumindest das bewegliche Sensorelement mittels des Schaummaterials zumindest bereichsweise separat gekapselt ist und das integrierte Bauteil bildet, wobei Anschlusselemente des beweglichen Sensorelements aus dem Schaummaterial herausragen und mit der Elektronikeinheit verbindbar oder verbunden sind.

Das bewegliche Sensorelement ist mittels des Schaummaterials derart bereichsweise gekapselt, dass es vor äußeren Umwelteinflüssen, wie Feuchtigkeit, Regen, Schmutzwasser, geschützt ist. Zudem ist als Schaummaterial ein solches elastisches Material vorgesehen, dass das bewegliche Sensorelement zusätzlich elastisch gelagert ist. Dabei kann das Schaummaterial gleichzeitig eine Verbindungs-, Rückstell- und Abdichtungsfunktion ausüben. Beispielsweise kann das bewegliche Sensorelement für die Verbindungsfunktion mittels des Schaummaterials mit der Elektronikeinheit verbunden sein. Darüber hinaus kann das Schaummaterial für eine Rückstellfunktion derart ausgebildet sein und das bewegliche Sensorelement derart kapseln, dass dieses nach Beendigung einer Auslösebewegung selbsttätig in eine Ausgangs- oder Ruhestellung zurückgestellt wird.

Die mit der Erfindung erzielten Vorteile bestehen insbesondere darin, dass das bewegliche Sensorelement des Betätigungssensors mittels des Schaummaterials im Multi-Sensormodul beweglich gelagert ist, wobei das Schaummaterial eine Verbindungs-, Rückstell- und Abdichtungsfunktion übernimmt.

In einer Weiterbildung ist das bewegliche Sensorelement als ein elastisches Auslöseelement ausgebildet. Dies ermöglicht in einfacher Art und Weise einen manuell kraftgesteuerten Druckschalter mit Rückstellfunktion. Zusätzlich kann das bewegliche Sensorelement als ein elektronisches Sensorelement, insbesondere eine kapazitive Sensorelektrode, geschaltet werden. Hierdurch kann das bewegliche Sensorelement zusätzlich zur Erkennung einer Annäherung eines Objekts verwendet werden und somit als Annäherungs- und/oder Gestensensor dienen.

Eine mögliche Ausführungsform sieht vor, dass das bewegliche Sensorelement ein Basiselement umfasst, das vollständig oder bereichsweise von dem Schaummaterial gekapselt ist. Das Basiselement bildet dabei ein elastisches Auslöseelement, welches zumindest in Richtung des festen Sensorelements mit dem Schaummaterial versehen ist. Beispielsweise ist das Basiselement als eine Auslöseplatte, insbesondere eine Blattfeder, ein Federblech oder eine Blechplatte, ausgebildet. Die Anschlusselemente des beweglichen Sensorelements sind vorzugsweise als Oberflächenanschlusselemente (= sogenannte SMD-Anschlusselemente) ausgebildet.

Zusätzlich können oder kann die erste Sensoreinheit und/oder die zweite Sensoreinheit jeweils von einem Vergussmaterial zumindest bereichsweise umgeben sein. Hierdurch sind die Sensoreinheiten selbst gegenüber äußeren Einflüssen, wie Feuchtigkeit, mechanischen Beanspruchungen, Schmutz, Wasser, Regen, geschützt.

In einer möglichen Ausführungsform ist die erste Sensoreinheit als ein kapazitiver Sensor zur Erkennung einer Annäherung eines Objekts an das Multi-Sensormodul und/oder zur Erfassung einer Geste eines Nutzers ausgebildet.

Die zweite Sensoreinheit ist insbesondere als ein Kraftsensor, insbesondere ein kraftgesteuerter kapazitiver oder induktiver Sensor, zum Ausführen einer Schaltfunktion, wie zum Beispiel zum Entriegeln eines Türschlosses und Öffnen einer Tür, ausgebildet.

Zur Betätigung des beweglichen Sensorelements ist beispielsweise ein separates Betätigungselement vorgesehen, das oberhalb und/oder unterhalb des beweglichen Sensorelements der zweiten Sensoreinheit angeordnet ist. Das Betätigungselement kann bereichsweise oder vollständig von dem Schaummaterial gekapselt und Teil des integrierten Bauteils sein. Beispielsweise kann das Betätigungselement bei einer Anordnung unterhalb des beweglichen Sensorelements Teil des integrierten Bauteils sein. Bei einer Anordnung oberhalb des beweglichen Sensorelements kann dieses in einem Abstand zu dem beweglichen Sensorelement angeordnet sein. In einer weiteren Alternative kann das oberhalb des beweglichen Sensorelements angeordnete Betätigungselement direkt auf dem beweglichen Sensorelement angeordnet sein und von dem Schaummaterial umgeben sein und somit ein Teil des integrierten Bauteils bilden.

Ein erfindungsgemäßes Griffmodul, insbesondere ein Außengriffmodul für ein bewegliches Fahrzeugelement, insbesondere eine Tür eines Fahrzeugs, umfasst zumindest ein Griffelement und ein Multi-Sensormodul, das als integrierte Baueinheit ausgebildet ist und als Montageeinheit am oder im Griffelement anordbar oder angeordnet ist. Dies ermöglicht eine variable Anordnung des Multi-Sensormoduls innen im Griffelement oder außen am Griffelement.

Das Griffelement umfasst dabei beispielsweise eine Griffaußenseite und eine Griffinnenseite, wobei die Baueinheit derart in das Griffelement montierbar ist, dass ein Annäherungs- und/oder Gestensensor des Multi-Sensormoduls an der Griffaußenseite und ein Betätigungssensor des Multi-Sensormoduls an der Griffinnenseite angeordnet sind.

Die mit der Erfindung erzielten Vorteile bestehen insbesondere darin, dass durch die Kombination eines Annäherungs- und/oder Gestensensors und eines Betätigungssensors in einem Griffmodul ein sicheres Öffnen des beweglichen Fahrzeugelements mittels des Betätigungssensors verbunden mit einer Komfortfunktion für das bewegliche Fahrzeugelement mittels des Gestensensors gegeben ist. Dabei sind die Sensoren - Annäherungs-, Gestensensor und/oder Betätigungssensor - geschützt, insbesondere gekapselt im Griffmodul angeordnet und somit vor Umweltbeanspruchungen geschützt. Darüber hinaus können der Annäherungs-, Gestensensor und/oder Betätigungssensor signaltechnisch miteinander kombiniert werden, wodurch weitere Komfortfunktionen ermöglicht sind und Störgrößen, wie Umwelteinflüsse, insbesondere Umgebungstemperaturen, Luftfeuchtigkeit, gefiltert werden können, so dass Fehlauslösungen vermieden sind.

Insbesondere können durch die Kombination des äußeren Annäherungs- und/oder Gestensensors mit dem inneren Betätigungssensor Umwelteinflüsse, wie sie zum Beispiel in einer Waschstraße für ein Fahrzeug auftreten, sicher gefiltert und erkannt werden, so dass eine Fehlauslösung sicher vermieden werden kann.

Darüber hinaus kann das Griffmodul mit einer mechanischen Notbetätigung ausgestattet sein. Beispielsweise durch Drücken auf einen vorderen Griffaußenbereich schwenkt das Griffelement, insbesondere dessen Betätigungselement, heraus und gibt einen Eingriff frei, in welchem ein zusätzlicher Notbetätigungsgriff für einen Bowdenzug zum manuellen Entriegeln und Öffnen des Türschlosses zugänglich ist.

In einer möglichen Ausführungsform umfasst das Griffelement ein Betätigungselement mit einer äußeren Betätigungsfläche und einen Griffträger, an welchem das Betätigungselement gehalten ist. Dabei sind das Betätigungselement an der Griffaußenseite und der Griffträger an der Griffinnenseite angeordnet. Unter Griffaußenseite wird im verbauten Zustand eine von außen zugängliche Seite eines beweglichen Fahrzeugelements, wie zum Beispiel einer Fahrzeugtür oder einer Heckklappe, verstanden. Unter Griffinnenseite wird im verbauten Zustand eine in Richtung des beweglichen Fahrzeugelements weisende Seite des Griffelements verstanden.

Der Betätigungssensor ist zur automatischen Entriegelung und zum automatischen Öffnen des Türschlosses der Tür ausgebildet und kann als ein integriertes Modul ausgebildet und vormontiert am oder im Multi-Sensormodul angeordnet sein. Das Multi-Sensormodul ist wiederum als eine separate integrierte Baueinheit, insbesondere als ein Montagemodul ausgebildet, das am oder im Griffträger variabel montiert werden kann. Darüber hinaus kann das Multi-Sensormodul am oder im Griffträger angeordnet werden. Beispielsweise kann das Multi-Sensormodul form- und/oder kraftschlüssig, zum Beispiel mittels einer Rastverbindung, Clipsverbindung, Steckverbindung, Nut-Feder-Verbindung, oder in anderer geeigneter Verbindung am oder im Griffträger angeordnet und gehalten sein.

Darüber hinaus kann durch die Ausbildung des Griffmoduls mit dem manuellen Betätigungselement ein elektrisches Türschloss sicher durch Druckbetätigung ausgelöst werden, wobei der innen liegende Betätigungssensor geschützt angeordnet ist und zusätzlich gekapselt, insbesondere eingehäust oder vergossen werden kann.

Eine Weiterbildung sieht vor, dass der Griffträger und das Betätigungselement den Betätigungssensor kapselnd umgeben. Durch die Ausbildung des Betätigungssensors als ein integriertes Modul und die zusätzliche Kapselung des Betätigungssensors durch den Griffträger und das Betätigungselement ist eine zusätzliche Dichtebene auf der Außenseite des Griffmoduls gegeben, so dass der Betätigungs-, insbesondere ein Hubmechanismus, des Betätigungselements ebenfalls abgedichtet ist.

Eine mögliche Ausführungsform sieht vor, dass der Betätigungssensor im Griffträger an einer Innenseite des Griffträgers im Bereich einer Durchgangsöffnung und gegenüberliegend zum Betätigungselement angeordnet und montiert ist. Dies ermöglicht einen kompakten Aufbau des Griffmoduls und kleine Betätigungshübe.

In einer weiteren Ausführungsform ist der Betätigungssensor mit der Elektronikeinheit gekoppelt. Durch die Kopplung mit der Elektronikeinheit kann das Griffmodul weitere Funktionen, zum Beispiel weitere elektronische Griff-, Schloss- und/oder Türfunktionen, übernehmen und ausführen.

Zum Beispiel umfasst die Elektronikeinheit eine Leiterplatte mit einer ersten Oberflächenseite und einer zweiten Oberflächenseite. Auf der ersten Oberflächenseite ist eine integrierte Schaltungsanordnung, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite ist der Betätigungssensor angeordnet.

Des Weiteren weist das Betätigungselement eine einer äußeren Betätigungsfläche gegenüberliegende Innenseite auf, die mittels eines Verbindungselements mit dem Griffträger zumindest im Bereich der Durchgangsöffnung abdichtend verbunden ist. Hierdurch ist die innenliegende Elektronikeinheit vor Beschädigung geschützt angeordnet.

Eine Weiterbildung sieht vor, dass der Betätigungssensor als ein Kraftsensor, insbesondere ein kraftgesteuerter kapazitiver Sensor, zum Entriegeln und Öffnen des Türschlosses und der Tür ausgebildet ist. Insbesondere ist der Betätigungssensor als ein sogenanntes MOC-Modul ausgebildet (= metall-over-cap-Modul), bei welchem die innen liegenden metallischen Sensorkomponenten nach außen hin gekapselt sind. Der Betätigungssensor wird durch Kraft beaufschlagt, zum Beispiel durch eine Druckkraft an der Griffaußenseite. Übersteigt die Kraft einen vorgegebenen Schwellwert, wird dies als ein Öffnungswunsch identifiziert und das Türschloss sicher entriegelt. Die Auslösung der Entriegelung erfolgt zum Beispiel durch Drücken des Griffmoduls an der Griffinnenseite gegen die Betätigungsfläche weg von der Fahrzeugkarosserie, so dass das Betätigungselement ins Griffinnere gedrückt wird. Bei einem hinreichend großen Betätigungshub des Betätigungselements in das Griffinnere nimmt das Betätigungselement das bewegliche Sensorelement, insbesondere ein Federblech oder eine Metallfeder, mit und drückt dieses ebenfalls in das Griffinnere, wodurch der Abstand zum festen Sensorelement, insbesondere einer Metallschicht, zum Beispiel einer Kupferschicht auf der zweiten Oberflächenseite der Leiterplatte, verändert wird und bei Überschreiten eines vorgegebenen Schwellwertes ein Öffnungssignal erzeugt wird und beispielsweise das Türschloss entriegelt oder eine Türbewegung gestoppt wird.

Beispielsweise umfasst der Betätigungssensor darüber hinaus ein Sensorgehäuse. Das feste Sensorelement kann beispielsweise direkt auf der zweiten Oberflächenseite der Leiterplatte angeordnet sein. Das bewegliche Sensorelement kann insbesondere im Abstand zum festen Sensorelement in einer Aufnahmeöffnung des Sensorgehäuses angeordnet sein. Das Sensorgehäuse und das bewegliche Sensorelement kapseln dabei das innen liegende feste Sensorelement nach außen hin ab. Das Sensorgehäuse ist insbesondere ein Kunststoffgehäuse und kann an die Leiterplatte angeformt, insbesondere angespritzt sein. Das Sensorgehäuse kann als ein 2-Komponenten-Gehäuse ausgebildet sein. Beispielsweise kann das Sensorgehäuse eine innen liegende weiche Gehäusewand und eine diese umgebende äußere harte Gehäusewand aufweisen. Das Sensorgehäuse dient als Abdichtung gegen Feuchtigkeit und Verschmutzung des Inneren der Sensoreinheit.

Im eingebauten Zustand des Betätigungssensors im Griffmodul ist das bewegliche Sensorelement im Bereich der Durchgangsöffnung derart angeordnet, dass es die Durchgangsöffnung von innen zumindest teilweise überdeckt. Darüber hinaus ist das Betätigungselement derart im Bereich der Durchgangsöffnung angeordnet, dass es die Durchgangsöffnung von außen zumindest teilweise überdeckt. Insbesondere ragt das Betätigungselement derart in die Durchgangsöffnung zumindest bereichsweise hinein, dass es in einer unbetätigten Stellung zum beweglichen Sensorelement beabstandet angeordnet ist. Dies ermöglicht einen kompakten Aufbau des Griffmoduls und kleine Betätigungshübe. Darüber hinaus sind die Betätigungskräfte einstellbar, insbesondere sind Schwellenwerte vorgebbar.

Eine weitere Ausführungsform sieht vor, dass das Betätigungselement ein Druckübertragungselement umfasst, das von der äußeren Betätigungsfläche nach innen in Richtung des Betätigungssensors ragt. Beispielsweise umfasst das Betätigungselement ein nach innen ragenden Betätigungsstößel, insbesondere einen Druckstift, zum Beispiel einen Bolzen oder Pin, welcher zur Betätigung des beweglichen Sensorelements in Druckrichtung bewegbar ist. Insbesondere ist das Betätigungselement derart betätigbar, dass es in Druckrichtung durch die Durchgangsöffnung hindurch bis zum beweglichen Sensorelement, zum Beispiel einem Auslöseelement, bewegbar ist und dieses bei weiterer Druckbetätigung in Richtung des festen Sensorelements bewegt. Hierdurch wird der Abstand zwischen dem beweglichen Sensorelement und dem festen Sensorelement verändert, insbesondere reduziert, so dass sich ein zwischen diesen vorhandenes Messfeld ändert. Das bewegliche Sensorelement, insbesondere das Auslöseelement, ist hierzu beispielsweise als eine metallische Blattfeder, eine Federplatte oder ein Federblech ausgebildet.

Des Weiteren kann das Betätigungselement eine einer äußeren Betätigungsfläche gegenüberliegende Innenseite aufweisen, die mittels eines Verbindungselements mit dem Griffträger zumindest im Bereich der Durchgangsöffnung abdichtend verbunden ist. Dabei kann das Verbindungselement zusätzlich als ein Rückstellelement ausgebildet sein, das bei einer Betätigung des Betätigungselements von einer unbetätigten Position in eine betätigte Position dieses bei Nichtbetätigung zurück in die unbetätigte Position stellt. Beispielsweise ist das Verbindungselement als ein Kunststoffstrang, insbesondere ein Gummi- oder Schaumstrang, ausgebildet. Das Verbindungselement kann auf der dem Betätigungssensor zugewandten Seite des Betätigungselements einen im Randbereich der Durchgangsöffnung angeordneten umlaufenden Dichtungsstrang bilden. Alternativ oder zusätzlich kann das Verbindungselement das Betätigungselement auf der dem Betätigungssensor zugewandten Seite randseitig umlaufen und gegen Feuchtigkeit und Verschmutzung abdichten. Hierzu ist das Verbindungselement aus einem Weichkomponentenmaterial, insbesondere aus einem Schaum-, Kunststoff- oder Gummimaterial gebildet.

Der Annäherungs- und/oder Gestensensor ist beispielsweise als ein segmentierter kapazitiver Sensor mit mehreren kapazitiven Sensorsegmenten ausgebildet. Der Annäherungs- und/oder Gestensensor ist beispielsweise auf einer Außenseite des Betätigungselements, im Betätigungselement im Bereich der äußeren Betätigungsfläche und/oder auf der der Griffaußenseite zugewandten Oberflächenseite der Elektronikeinheit angeordnet. Die Sensorsegmente sind signaltechnisch kombiniert und mit einer Auswerteelektronik der Elektronikeinheit in herkömmlicher Weise zur kontaktlosen Erfassung einer Objektannäherung und/oder einer Geste verbunden, so dass zum Beispiel eine berührungslose Wischbewegung im Bereich des äußeren Gestensensors aufgrund von kapazitiven Änderungen der Sensorsegmente erkannt wird. Aufgrund des zeitlichen Versatzes der kapazitiven Änderungen der Sensorsegmente kann eine Richtung der berührungslosen Wischbewegung detektiert werden und entsprechend ein Verfahrsignal für das bewegliche Fahrzeugelement in die ermittelte Richtung ausgelöst werden, so dass das bewegliche Fahrzeugelement in die ermittelte Richtung bewegt wird.

Mittels des inneren Betätigungssensors kann dann durch punktuelles Berühren der Betätigungsfläche die ausgelöste Bewegung des Fahrzeugelements, wie einer Tür, an jeder beliebigen Position gestoppt und auf Wunsch durch nochmalige Berührung, insbesondere Drücken, der Betätigungsfläche wieder angefahren werden.

Darüber hinaus kann ein Verriegelungssensor in dem Griffmodul integriert sein, welcher einen Verriegelungsbefehl für das Türschloss bei geschlossenem Fahrzeugelement, insbesondere geschlossener Tür, Front-/Motorhaube oder Heckklappe, identifiziert und auslöst.

Ferner betrifft die Erfindung ein bewegliches Fahrzeugelement, das zumindest ein Griffmodul, wie oben beschrieben, umfasst, in oder an welchem das Multi-Sensormodul anordbar oder angeordnet ist. Bei dem beweglichen Fahrzeugelement kann es sich um ein manuell zu öffnendes oder elektrisch zu öffnendes, insbesondere aufzuschwenkendes oder aufzuschiebendes, Element, wie eine Fahrzeugtür, eine Schiebetür, eine Front- oder Motorhaube, eine Heckklappe eines Fahrzeugs handeln.

Ausführungsbeispiele der Erfindung werden anhand von Zeichnungen näher erläutert. Dabei zeigen:
- Figur 1: in Explosionsdarstellung eine erste Ausführungsform eines Multi-Sensormoduls,
- Figur 2: im zusammengesetzten Zustand die erste Ausführungsform des Multi-Sensormoduls gemäß Figur 1,
- Figur 3: in Explosionsdarstellung eine zweite Ausführungsform eines Multi-Sensormoduls,
- Figur 4: im zusammengesetzten Zustand die zweite Ausführungsform des Multi-Sensormoduls gemäß Figur 3,
- Figur 5: in Explosionsdarstellung eine dritte Ausführungsform eines Multi-Sensormoduls,
- Figur 6: im zusammengesetzten Zustand eine vierte Ausführungsform eines Multi- Sensormoduls,
- Figur 7: im zusammengesetzten Zustand eine fünfte Ausführungsform eines Multi- Sensormoduls,
- Figur 8: im zusammengesetzten Zustand eine sechste Ausführungsform eines Multi-Sensormoduls,
- Figur 9: in perspektivischer Darstellung ein Multi-Sensormodul als Montageeinheit,
- Figur 10: schematisch eine Schnittdarstellung eines Griffmoduls mit einem Multi- Sensormodul,
- Figur 11: schematisch in Draufsicht ein Griffmodul,
- Figur 12: schematisch in Draufsicht ein Griffmodul, insbesondere Multifunktions-Griffmodul, welches für eine Gestensteuerung und eine Druckbetätigung eingerichtet ist,
- Figur 13: schematisch in Seitenansicht ein Fahrzeug mit einem beweglichen Fahrzeugelement, welches ein Multifunktions-Griffmodul zur Entriegelung eines Türschlosses und zur Steuerung von Griff-, Schloss- und/oder Türfunktionen umfasst,
- Figur 14: schematisch in Draufsicht das Griffmodul mit einem Annäherungs- und/oder Gestensensor auf einer Griffaußenseite und einem Betätigungssensor auf einer Griffinnenseite,
- Figur 15: schematisch in perspektivischer Teilansicht das Griffmodul mit einem Annäherungs- und/oder Gestensensor auf einer Griffaußenseite und einem Betätigungssensor auf einer Griffinnenseite,
- Figur 16: schematisch in Explosionsdarstellung das Griffmodul mit einem Annäherungs- und/oder Gestensensor auf einer Griffaußenseite und einem Betätigungssensor auf einer Griffinnenseite,
- Figuren 17: schematisch eine Oberseite einer Elektronikeinheit für das Griffmodul,
- Figuren 18: schematisch eine Unterseite einer Elektronikeinheit für das Griffmodul, und
- Figur 19: schematisch in Blockdarstellung Komponenten einer Elektronikeinheit des Multi-Sensormoduls.

Einander entsprechende Teile sind in allen Figuren mit den gleichen Bezugszeichen versehen.

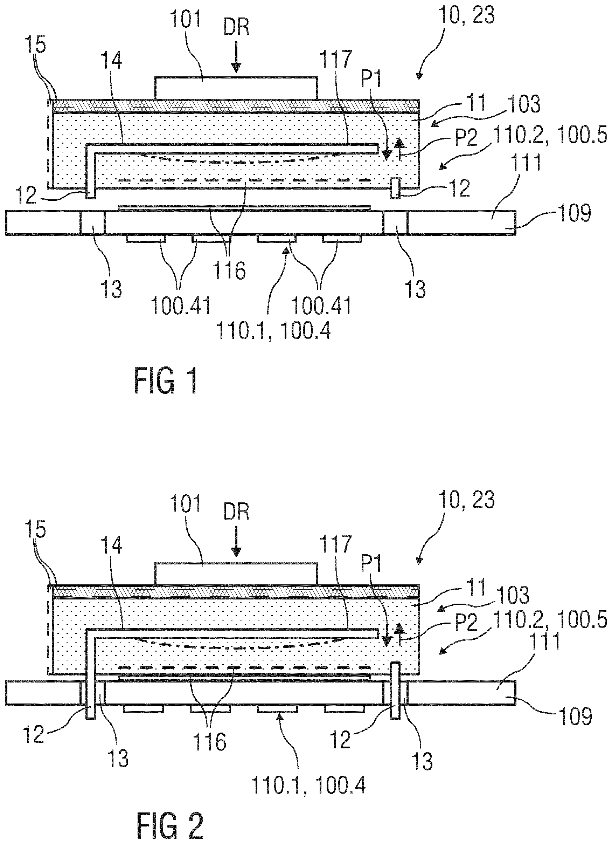

**Figur 1** zeigt schematisch in Explosionsdarstellung eine mögliche Ausführungsform für ein Multi-Sensormodul 10, insbesondere ein elektronisches Multi-Sensormodul 10. **Figur 2** zeigt das Multi-Sensormodul 10 in zusammengebauter Fassung.

Das Multi-Sensormodul 10 umfasst zumindest eine Elektronikeinheit 109, eine erste Sensoreinheit 110.1 und eine zweite Sensoreinheit 110.2. Die erste Sensoreinheit 110.1 ist als ein Annäherungs- und/oder Gestensensor 100.4 ausgebildet. Die zweite Sensoreinheit 110.2 als ein Betätigungssensor 100.5 ausgebildet.

Die Elektronikeinheit 109 ist elektrisch mit den Sensoreinheiten 110.1, 110.2 zur Auslösung eines Signals, insbesondere eines Schaltsignals, verbunden. Der Betätigungssensor 100.5 ist als ein zumindest bereichsweise mittels eines Schaummaterials 11 gekapseltes und integriertes Bauteil 103 ausgebildet und auf einer Seite der Elektronikeinheit 109 montierbar oder montiert.

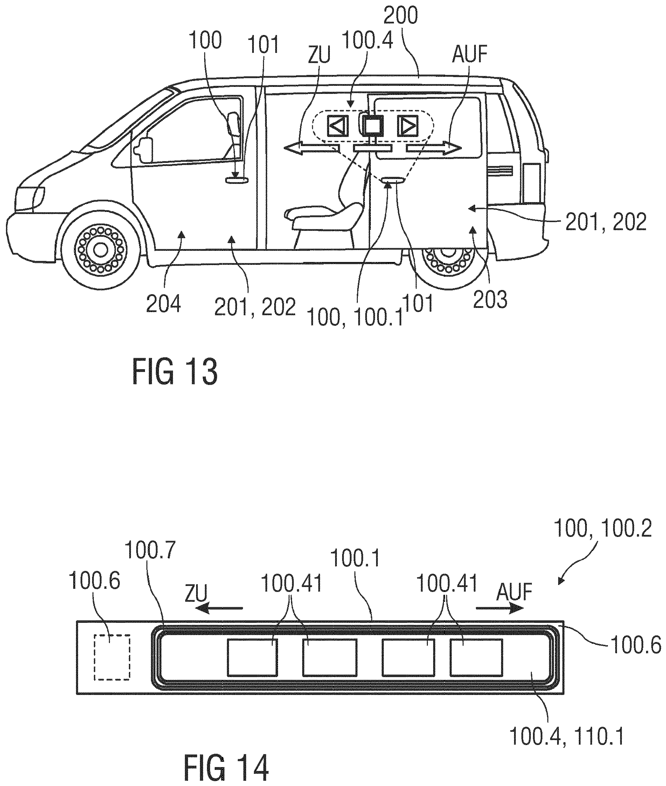

Der Annäherungs- und/oder Gestensensor 100.4 ist segmentiert ausgebildet und auf einer gegenüberliegenden Seite der Elektronikeinheit 109 montierbar oder montiert. Beispielsweise umfasst der Annäherungs- und/oder Gestensensor 100.4 mehrere Sensorsegmente 100.41. Der Annäherungs- und/oder Gestensensor 100.4 ist beispielsweise als ein segmentierter kapazitiver Sensor für Gestik ausgebildet. Die Sensorsegmente 100.4 erkennen bei einer berührungslosen Wischbewegung die kapazitive Veränderung. Aufgrund eines zeitlichen Versatzes der kapazitiven Veränderung der einzelnen Sensorsegmente 100.4 kann eine Richtung der Wischbewegung detektiert werden. Daraus kann beispielsweise ein Verfahrwunsch eines beweglichen Fahrzeugelements 201; zum Beispiel einer Fahrzeugtür 202 (dargestellt in **Figur 13**), abgeleitet werden, so dass eine entsprechende Steuerung die Fahrzeugtür 202 in die gewünschte Richtung verfährt.

Der Betätigungssensor 100.5 reagiert auf eine mechanische Beanspruchung, zum Beispiel auf eine Beaufschlagung mittels Kraft, zum Beispiel Druckkraft. Dies ermöglicht eine sichere Auslösung eines Öffnungswunsches. Beispielsweise wird das Griffelement 100.1 im Bereich des Betätigungssensors 100.5 durch Drücken in Richtung Fahrzeugkarosserie mit einer Druckkraft beaufschlagt, wodurch sich ein Abstand des Betätigungssensors 100.5, insbesondere ein Abstand eines MoC-Bleches zur Elektronikeinheit 109 ändert. Bei Überschreitung eines Schwellwertes für den Abstand wird ein entsprechender Öffnungswünsch detektiert und ein entsprechendes Schloss geöffnet oder entriegelt.

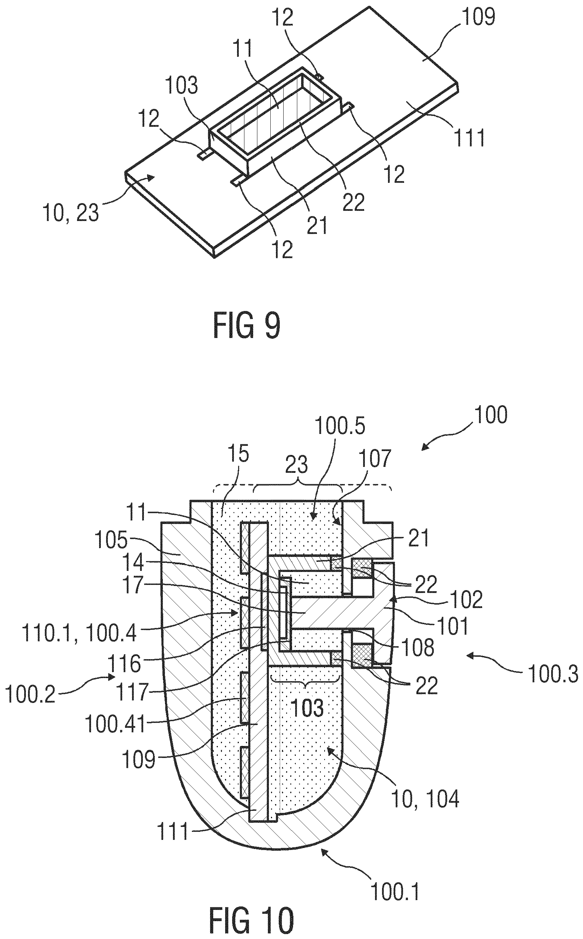

Das Multi-Sensormodul 10 kombiniert somit einen äußeren segmentierten kapazitiven Annäherungs- und/oder Gestensensor 100.4 mit einem inneren Betätigungssensor 100.5, insbesondere einen Drucksensor, zum Beispiel einen sogenannten MoC-Sensor. Diese Kombination ermöglicht ein sicheres Öffnen, zum Beispiel einer Schiebetür, mittels des Betätigungssensors 100.5 und eine Komfortfunktion mittels des segmentierten Annäherungs- und/oder Gestensensors 100.4. Somit kann ein zugehöriges Griffmodul 100 (dargestellt in Figuren 10ff.) über eine Sensordiversität, insbesondere eine mechanische Sensorredundanz, plausibel und sicher geöffnet werden.

Durch eine solche Kombination des Betätigungssensors 100.5 mit äußeren Sensorsegmenten 100.41 für die Gestikfunktion können äußere Einflüsse, wie zum Beispiel Nässe einer Waschstraße, sicher von dem Betätigungswunsch differenziert und gefiltert werden. Erkennen zum Beispiel alle Sensorsegmente 100.41 zeitgleich eine Änderung, so wird kein Öffnungswunsch detektiert.

Darüber hinaus kann das Multi-Sensormodul 10 zusätzlich zumindest bereichsweise von einem Vergussmaterial 15 umgeben und als eine integrierte Baueinheit 23 ausgebildet sein. Insbesondere bildet das gekapselte und integrierte Bauteil 103 eine Vormontageeinheit, die in einem Vormontagezustand auf der Elektronikeinheit 109 montierbar oder montiert ist.

Die zweite Sensoreinheit 110.2, insbesondere der Betätigungssensor 100.5, umfasst zumindest ein festes Sensorelement 116 und ein bewegliches Sensorelement 117.

Das feste Sensorelement 116 ist beabstandet und gegenüberliegend zu dem beweglichen Sensorelement 117. Die Elektronikeinheit 109 ist mit den Sensorelementen 116, 117 zum Auslösen eines Schaltsignals verbunden. Die Elektronikeinheit 109 umfasst beispielsweise eine Leiterplatte 111.

Das feste Sensorelement 116 ist dabei beispielsweise als eine Metallschicht, insbesondere eine Kupferschicht, auf der Leiterplatte 111 ausgebildet.

Darüber hinaus ist das bewegliche Sensorelement 117 mittels eines Schaummaterials 11 zumindest bereichsweise gekapselt und bildet das integrierte Bauteil 103.

Dabei kann das gekapselte und integrierte Bauteil 103 mit dem Betätigungssensor 100.5 eine Vormontageeinheit bilden, wie in **Figur 1** in Explosionsdarstellung gezeigt ist. Die Vormontageeinheit und somit das Bauteil 103 ist dann in diesem Vormontagezustand (gekapselt) auf einer Seite der Elektronikeinheit 109 montierbar. Auf der gegenüberliegenden Seite der Elektronikeinheit 109 ist der segmentierte Annäherungs- und/oder Gestensensor 100.4 montierbar oder montiert. Im montierten Zustand des integrierten Bauteils 103 auf der Elektronikeinheit 109 bilden diese zusammen die integrierte Baueinheit 23 des Sensormoduls 10.

Wie in **Figur 1** anhand der gestrichelten Darstellung des festen Sensorelements 116 gezeigt, kann optional das feste Sensorelement 116 ebenfalls vom Schaummaterial 11 gekapselt sein.

Zum Anschließen des beweglichen Sensorelements 117 des integrierten Bauteils 103 an die Elektronikeinheit 109 umfasst das bewegliche

Sensorelement 117 Anschlusselemente 12, die aus dem Schaummaterial 11 herausragen und mit der Elektronikeinheit 109 zu verbinden sind (**Figur 1**) oder verbunden, zum Beispiel gelötet, sind (**Figur 2**).

**Figuren 1 und 2** zeigen als Anschlusselemente 12 Steckkontaktierungen. Hierzu sind die Anschlusselemente 12 als vertikale elektrische Steckverbindungen ausgebildet, die durch Durchgangsöffnungen 13 der Leiterplatte 111 hindurch gesteckt werden und welche dann mit der Leiterplatte 111 auf der gegenüberliegenden Seite mit einer Leiterbahn oder einem Anschlusskontakt verbunden, insbesondere verlötet werden.

Das bewegliche Sensorelement 117, zum Beispiel ein Federelement, wie eine Blattfeder, oder ein Metallblech, ist mittels des Schaummaterials 11 derart bereichsweise gekapselt, dass es vor äußeren Umwelteinflüssen, wie Feuchtigkeit, Regen, Schmutzwasser, geschützt ist. Zumindest das bewegliche Sensorelement 117 ist vom Schaummaterial 11 umgeben und bildet mit diesem zusammen das integrierte Bauteil 103. Die Anschlusselemente 12 ragen somit auch aus dem integrierten Bauteil 103 heraus.

Zudem ist als Schaummaterial 11 ein solches elastisches Material vorgesehen, durch welches das bewegliche Sensorelement 117 zusätzlich elastisch gelagert ist.

Dabei kann das Schaummaterial 11 gleichzeitig eine Verbindungs-, Rückstell- und Abdichtungsfunktion ausüben. Für die Verbindungsfunktion kann das bewegliche Sensorelement 117 optional mittels des Schaummaterials 11 mit der Elektronikeinheit 109, insbesondere der Leiterplatte 111, verbunden sein. Darüber hinaus kann das Schaummaterial 11 für eine Rückstellfunktion derart ausgebildet sein und das bewegliche Sensorelement 117 derart kapseln, dass dieses nach Beendigung einer Auslösebewegung selbsttätig in eine Ausgangs- oder Ruhestellung zurückgestellt wird, wie dies anhand der Pfeile P1, P2 dargestellt ist.

Mittels des Schaummaterials 11 ist das bewegliche Sensorelement 117 im Multi-Sensormodul 10 beweglich gelagert, wobei das Schaummaterial 11 eine Verbindungs-, Rückstell- und Abdichtungsfunktion übernimmt. Optional kann das das feste Sensorelement 116 der zweiten Sensoreinheit 110.2 ebenfalls vom Schaummaterial 11 gekapselt sein.

In einer Weiterbildung ist das bewegliche Sensorelement 117 als ein elastisches Auslöseelement ausgebildet. Hierdurch kann die zweite Sensoreinheit 110.2 als ein manuell kraftgesteuerter Druckschalter mit Rückstellfunktion. Beispielsweise ist die zweite Sensoreinheit 110.2 als ein Kraftsensor, insbesondere ein kraftgesteuerter kapazitiver oder induktiver Sensor, zum Ausführen einer Schaltfunktion ausgebildet.

Dazu ist zusätzlich ein Betätigungselement 101 vorgesehen, das beispielsweise oberhalb des beweglichen Sensorelements 117, einem elastischen Auslöseelement, angeordnet ist.

**Figuren 1 und 2** zeigen das Betätigungselement 101 als ein Stößel oder Druckknopf, der oberhalb des Schaummaterials 11 angeordnet ist. Das Betätigungselement 101 ist dabei insbesondere in Druckrichtung DR betätigbar.

Zusätzlich kann das bewegliche Sensorelement 117 als ein elektronisches Sensorelement, insbesondere eine kapazitive Sensorelektrode, mittels der Elektronikeinheit 109 geschaltet werden. Hierdurch kann die zweite Sensoreinheit 110.2 nicht nur als Druckschalter sondern zusätzlich zur Erkennung einer Annäherung eines Objekts verwendet werden und somit als Annäherungssensor dienen.

Das bewegliche Sensorelement 117 umfasst ein Basiselement 14, das vollständig oder bereichsweise von dem Schaummaterial 11 gekapselt ist. Das bewegliche Sensorelement 117 ist zumindest in Richtung des festen Sensorelements 116 mit dem Schaummaterial 11 versehen. Mit anderen Worten: Das Schaummaterial 11 ist zumindest zwischen dem beweglichen Sensorelement 117 und dem festen Sensorelement 116 angeordnet.

Das Basiselement 14 ist insbesondere als eine Auslöseplatte, insbesondere ein Federblech oder eine Blechplatte, ausgebildet. Im Ausführungsbeispiel nach **Figuren 1 und 2** sind die Anschlusselemente 12 als Steckkontakte ausgebildet und ragen aus dem Schaummaterial 11 vertikal nach unten hervor.

Zusätzlich kann die zweite Sensoreinheit 110.2 von einem Vergussmaterial 15 zumindest bereichsweise umgeben sein. Insbesondere kann eine äußere Schicht um das Schaummaterial 11 herum optional mit dem Vergussmaterial 15 versehen sein. Zusätzlich kann das Sensormodul 10, insbesondere deren miteinander vormontierte, elektronische Komponenten, wie zum Beispiel die Sensoreinheiten 110.1, 110.2 und die Elektronikeinheit 109, zumindest bereichsweise von dem Vergussmaterial 15 umgeben sein. Das Sensormodul 10 ist dabei als eine integrierte Baueinheit 23, insbesondere eine separate Montageeinheit oder ein separates Montagemodul, ausgebildet.

Die erste Sensoreinheit 110.1 ist als Annäherungs- und/oder Gestensensor 100.4, insbesondere als ein herkömmlicher kapazitiver Sensor ausgebildet.

Der Annäherungs- und/oder Gestensensor 100.4 dient insbesondere der berührungslosen Erfassung einer Annäherung und/oder einer Bewegung eines Objektes, wie zum Beispiel einer Hand, des Multi-Sensormoduls 10.

Der Annäherungs- und/oder Gestensensor 100.4 ist beispielsweise als ein segmentierter kapazitiver Sensor mit mehreren kapazitiven Sensorsegmenten 100.41 ausgebildet. Die Sensorsegmente 100.41 sind signaltechnisch kombiniert und mit einer Auswerteelektronik der Elektronikeinheit 109 verbunden, so dass zum Beispiel eine berührungslose Annäherung einer Hand und/oder eine Wischbewegung im Bereich des äußeren Annäherungs- und/oder Gestensensors 100.4 aufgrund von kapazitiven Änderungen der Sensorsegmente 100.41 erkannt wird.

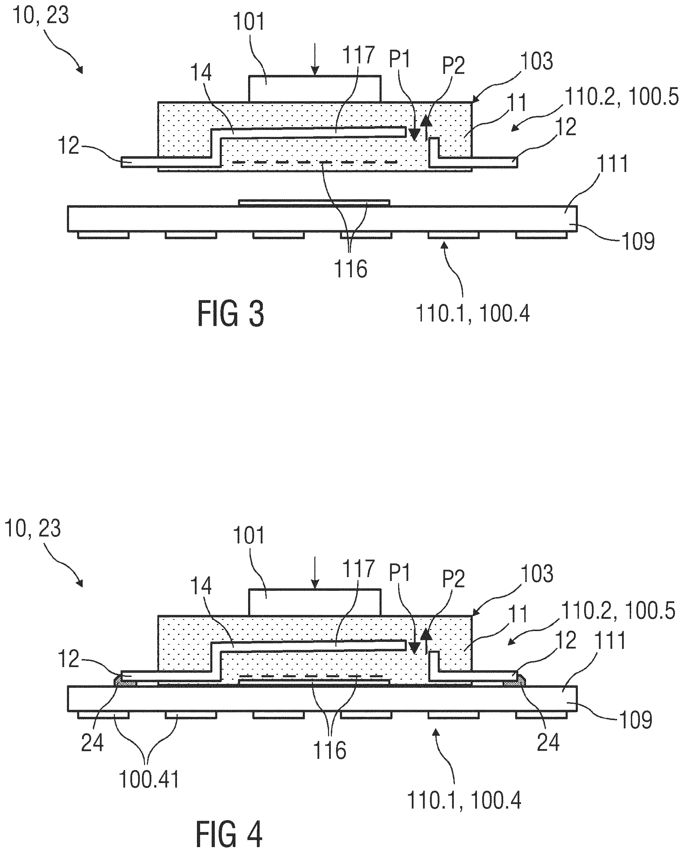

**Figuren 3 und 4** zeigen eine weitere optionale Ausführungsform des elektronischen Multi-Sensormoduls 10. Anstelle von Steckkontakten sind die Anschlusselemente 12 als Oberflächenanschlusselemente (= sogenannte SMD-Anschlüsse) des integrierten Bauteils 103, insbesondere der Vormontageeinheit, ausgebildet und ragen horizontal aus dem Schaummaterial 11 hervor, so dass diese Anschlusselemente 12 mit der Elektronikeinheit 109, insbesondere mit einer Leiterbahn auf der oberen Oberflächenseite der Leiterplatte 111 verbunden werden können (**Figur 3**) bzw. sind (**Figur 4**). Beispielsweise sind die Anschlusselemente 12 als lötfähige Anschlussflächen 24 direkt auf die Leiterplatte 111 gelötet.

Eine solche Ausbildung der zweiten Sensoreinheit 110.2, insbesondere des Betätigungssensors 100.5, mit Anschlusselementen 12 als Oberflächenanschlusselemente ermöglicht eine großflächige Nutzung der abgewandten Leiterplattenseite für die erste Sensoreinheit 110.1. Hierdurch können mehr Sensorsegmente 100.41 für das Multi-Sensormodul 10 vorgesehen sein und somit eine größere Fläche als Annäherungs- und/oder Gestensensor 100.4 genutzt werden.

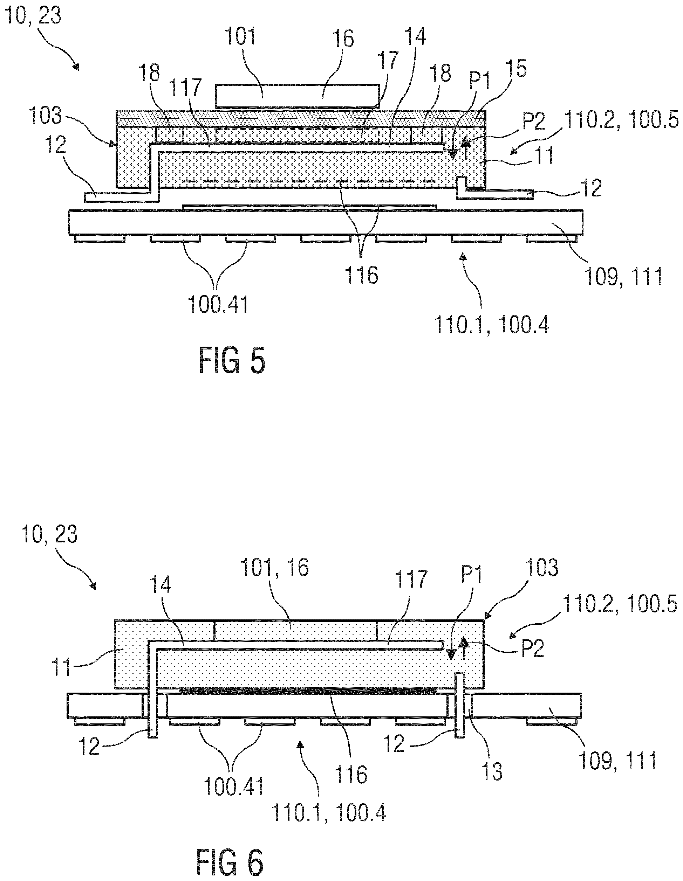

**Figur 5** zeigt eine weitere optionale Ausführungsform des elektronischen Multi-Sensormoduls 10 mit einem zumindest teilweise gekapselten Betätigungselement 101. Im Ausführungsbeispiel nach **Figur 5** ist das Betätigungselement 101 zweiteilig ausgebildet und umfasst einen Betätigungsstößel 16 und einen im Schaummaterial 11 angeordneten Gegenstößel 17. Zusätzlich können Abstandselemente 18 vorgesehen sein, um die Betätigungsbewegung, insbesondere eine Hubbewegung, des Betätigungselements 101 zu begrenzen. Diese Abstandselemente 18 können auch bei den anderen gezeigten Ausführungsbeispielen für das elektronische Multi-Sensormodul 10 vorgesehen sein. Die Abstandselemente 18 können als ein umlaufender Materialstrang ausgebildet sein und zusätzlich zur Stützfunktion und Anschlagsfunktion eine Dichtungsfunktion realisieren.

**Figur 6** zeigt eine weitere optionale Ausführungsform des elektronischen Multi-Sensormoduls 10, wobei das Betätigungselement 10 als Betätigungsstößel 16 vollständig vom Schaummaterial 11 gekapselt ist und damit Teil des integrierten Bauteils 103, insbesondere der Vormontageeinheit, ist.

In einer weiteren, nicht näher dargestellten Option kann ein mehrteiliges Betätigungselement 101 einen Gegenstößel 17, der unterhalb des beweglichen Sensorelements 117 als Teil des integrierten Bauteils 103 ausgebildet ist, und einen Betätigungsstößel 16, der oberhalb des beweglichen Sensorelements 117 angeordnet ist, umfassen.

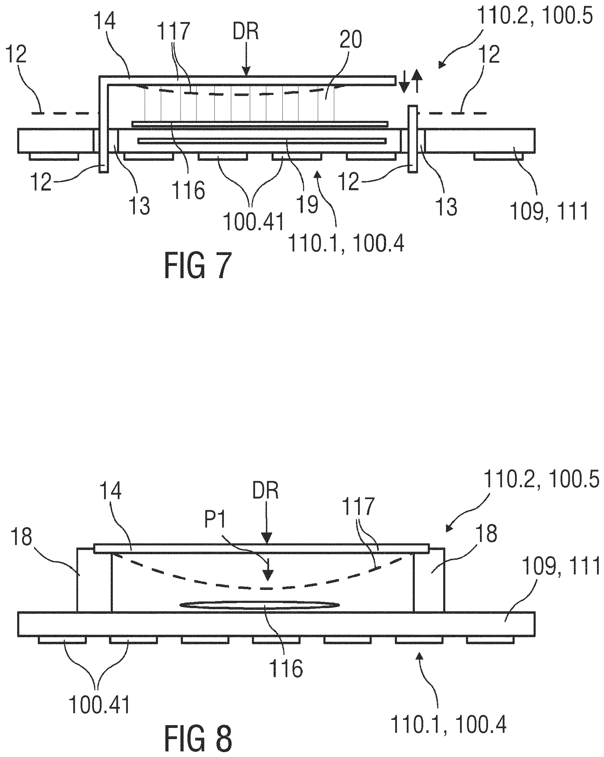

**Figur 7** zeigt die Ausbildung der zweiten Sensoreinheit 110.2 als kapazitiven Sensor, wobei das bewegliche Sensorelement 117 und das feste Sensorelement 116 jeweils Elektroden bilden, die voneinander beabstandet sind, so dass zwischen diesen bei aktivierter zweiter Sensoreinheit 110.2 ein Messfeld 20 ausgebildet ist, so dass beim Drücken des beweglichen Sensorelements 117 in Druckrichtung DR die Änderung des kapazitiven Messfeldes 20 erfasst und zur Bestimmung des Betätigungshubes verwendet wird, um bei einem hinreichend großen Betätigungshub eine Schaltfunktion auszulösen.

Zusätzlich kann auf der vom beweglichen Sensorelement 117 abgewandten Seite des festen Sensorelements 116 eine Abschirmung 19, insbesondere als eine Metallschicht in der Leiterplatte 111, vorgesehen sein. Zur besseren Übersicht wurden das Schaummaterial 11 und das Betätigungselement 101 nicht dargestellt.

**Figur 8** zeigt die Ausbildung der zweiten Sensoreinheit 110.2 als induktiven Sensor, wobei das bewegliche Sensorelement 117 als eine Metallfeder oder Metallblech und das feste Sensorelement 116 als eine Spule ausgebildet sind, die voneinander beabstandet sind, so dass beim Drücken des beweglichen Sensorelements 17 in Druckrichtung DR die Änderung der Induktivität der Spule erfasst und zur Bestimmung des Betätigungshubes/der Kraft verwendet wird, um bei einer hinreichend großen Induktivitätsänderung eine Schaltfunktion auszulösen.

**Figur 9** zeigt das elektronische Multi-Sensormodul 10 in perspektivischer Darstellung mit der Elektronikeinheit 109 als Leiterplatte 111 und dem integrierten Bauteil 103, umfassend das Schaummaterial 11 und darin gekapselte bewegliche Sensorelemente 117. Das Schaummaterial 11 kann zusätzlich von einem Sensorgehäuse 21 umgeben sein. Das Sensorgehäuse 21 kann darüber hinaus zur zusätzlichen Abdichtung des integrierten Bauteils 103 mit einem Dichtungsstrang 22 versehen sein. Das integrierte Bauteil 103 als Vormontageeinheit ist auf einer Seite der Elektronikeinheit 109 montiert. Darüber hinaus ist das integrierte Bauteil 103 über die Anschlusselemente 12 mit der Elektronikeinheit 109 signaltechnisch verbunden.

Das elektronische Multi-Sensormodul 10 kann mit allen Komponenten, der Elektronikeinheit 109, der ersten Sensoreinheit 110.1 (in **Figur 9** nicht dargestellt, da auf der abgewandten Seite der Elektronikeinheit 109 angeordnet) und der zweiten Sensoreinheit 110.2 zu einer integrierten Baueinheit 23 vormontiert sein, die als Ganzes in ein Griffmodul 100 montiert werden kann, das nachfolgend beispielhaft beschrieben wird.

**Figur 10** zeigt eine mögliche Ausführungsform für ein Griffmodul 100 mit einem elektronischen Multi-Sensormodul 10, das als eine integrierte Baueinheit 23 im Griffmodul 100 angeordnet ist.

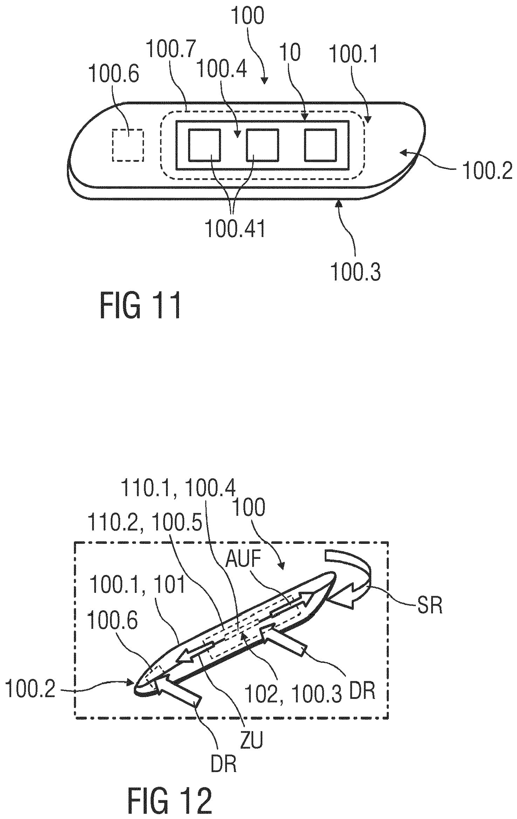

Das Griffmodul 100 ist ein Außengriffmodul für ein bewegliches Fahrzeugelement 201, insbesondere eine Fahrzeugtür 202 eines Fahrzeugs 200, wie es in den nachfolgenden **Figuren 11 bis 19** im Detail gezeigt ist.

Das Griffmodul 100 umfasst beispielsweise zumindest das elektronische Multi-Sensormodul 10 als integrierte Baueinheit 23 und einen Griffträger 105, an oder in welchem das Multi-Sensormodul 10 vormontiert und anschließend gekapselt angeordnet ist. An dem Multi-Sensormodul 10 ist wiederum die integrierte Baueinheit 23 als Vormontageeinheit vormontiert.

Das elektronische Multi-Sensormodul 10 in Form der integrierten Baueinheit 23 kann als Ganzes in dem Griffmodul 100 verbaut, insbesondere vormontiert, werden.

Dabei sind durch die Ausbildung des Griffmoduls 100 mit dem innen liegenden Multi-Sensormodul 10 mit gekapselten elektronischen Komponenten, der ersten Sensoreinheit 110.1 als Annäherungs- und/oder Gestensensor 100.4 und der zweiten Sensoreinheit 110.2 als Betätigungssensor 100.5, diese Komponenten geschützt angeordnet. Zusätzlich kann das Multi-Sensormodul 10 innerhalb des Griffmoduls 100 mittels eines Vergussmaterials 15 gekapselt sein.

Das Griffmodul 100 umfasst ein Griffelement 100.1, das eine Griffaußenseite 100.2 und eine Griffinnenseite 100.3 aufweist.

Das Multi-Sensormodul 10 ist dabei derart in dem Griffmodul 100 angeordnet, dass der Annäherungs- und/oder Gestensensor 100.4 des Multi-Sensormoduls 10 an oder in der Griffaußenseite 100.2 und der Betätigungssensor 100.5 an oder in der Griffinnenseite 100.3 angeordnet sind.

In einer möglichen Ausführungsform ist das elektronische Multi-Sensormodul 10 als eine Auslöseeinheit 104 zum automatischen Auslösen einer Funktion, insbesondere zum Auslösen einer Entriegelung und eines automatischen Öffnens des Türschlosses der Fahrzeugtür 202 ausgebildet. Durch die Integration von Elektronikeinheit 109, erster Sensoreinheit 110.1 und zweiter Sensoreinheit 110.2 in das elektronische Multi-Sensormodul 10 und damit in die Auslöseeinheit 104 kann das Multi-Sensormodul 10 zusätzlich zur Auslösefunktion weitere Funktionen, zum Beispiel weitere elektronische Griff-, Schloss- und/oder Türfunktionen, übernehmen und ausführen.

Das Betätigungselement 101 ist oberhalb des beweglichen Sensorelements 117 im Griffträger 105 angeordnet und umfasst den Betätigungsstößel 16, der durch die Durchgangsöffnung 108 im Griffträger 105 hindurchragt und das bewegliche Sensorelement 117 betätigt und infolgedessen mittels der Elektronikeinheit 109 ein Betätigungssignal erzeugt zum Auslösen einer Schaltfunktion für das Türschloss.

Durch die Ausbildung des Multi-Sensormoduls 10 als integrierte Baueinheit 23 im Griffmodul 100 und die zusätzliche Kapselung des Multi-Sensormoduls 10 durch das Vergussmaterial 15 innen und nach außen durch den Griffträger 105, das Betätigungselement 101 und den Dichtungssträngen 22 ist eine zusätzliche Dichtebene auf der Außenseite des Griffmoduls 100 gegeben, so dass der Betätigungs-, insbesondere ein Hubmechanismus, des Betätigungselements 101 ebenfalls abgedichtet ist.

Die integrierte Baueinheit 23 des Multi-Sensormoduls 10 ist im Griffträger 105 an einer Innenseite 107 des Griffträgers 105 im Bereich der Durchgangsöffnung 108 und gegenüberliegend zum Betätigungselement 101 angeordnet und montiert, insbesondere als eine Vormontageinheit vormontierbar oder vormontiert. Dies ermöglicht einen kompakten Aufbau des Griffmoduls und kleine Betätigungshübe.

**Figur 11** zeigt schematisch in Draufsicht ein Griffmodul 100 mit dem Griffelement 100.1 mit der Griffaußenseite 100.2 und der Griffinnenseite 100.3.

Das Griffmodul 100 ist darüber hinaus mit dem Multi-Sensormodul 10 versehen, wobei der Annäherungs- und/oder Gestensensor 100.4 mit den Sensorsegmenten 100.41 an oder in der Griffaußenseite 100.2 und der Betätigungssensor 100.5 an oder in der Griffinnenseite 100.3 (in **Figur 9** gezeigt) angeordnet sind.

Zusätzlich kann eine Steckeranbindung 100.6 in das Griffmodul 100, beispielsweise im Griffträger 105 und/oder das Betätigungselement 101, integriert, insbesondere eingeformt oder eingespritzt, sein. Optional kann eine Antenne 100.7, insbesondere eine NFC-Antenne, in das Griffmodul 100, insbesondere in den Griffträger 105 und/oder das Betätigungselement 101, integriert, insbesondere eingeformt oder eingespritzt, sein.

Der Annäherungs- und/oder Gestensensor 100.4 dient insbesondere der berührungslosen Erfassung einer Annäherung und/oder einer Bewegung eines Objektes, wie zum Beispiel einer Hand, im Bereich des Griffmoduls 100.

Der Betätigungssensor 100.5 dient insbesondere der Erfassung einer Betätigungskraft, beispielsweise der Erfassung eines Drückens gegen die Griffinnenseite 100.3, so dass diese nach innen bewegt wird.

**Figur 12** zeigt das Griffmodul 100 mit den aus der Kombination von Betätigungssensor 100.5 und Annäherungs- und/oder Gestensensor 100.4 möglichen Bedienfunktionen.

Das Griffelement 100.1 umfasst im Bereich der Griffinnenseite 100.3 ein Betätigungselement 101 mit einer äußeren (nach innen in Richtung Karosserie/Fahrzeugelement 201 gerichteten) Betätigungsfläche 102. Das Betätigungselement 101 ist dabei insbesondere in Druckrichtung DR betätigbar, um den im Bereich der Griffinnenseite 100.3 angeordneten Betätigungssensor 100.5 auszulösen.

Zusätzlich oder optional kann das Betätigungselement 101 in Schwenkrichtung SR betätigbar sein.

Das Griffmodul 100 umfasst darüber hinaus auf der Griffaußenseite 100.2 den Annäherungs- und/oder Gestensensor 100.4, der in dem Betätigungselement 101 integriert ist. Der Annäherungs- und/oder Gestensensor 100.4 ermöglicht eine berührungslose Annäherungs- und/oder Gestenerkennung und einer aus der erfassten Annäherung bzw. Geste resultierende Schaltfunktion bzw. Gestensteuerung für eine Schließrichtung ZU und eine Öffnungsrichtung AUF.

**Figur 13** zeigt schematisch in Seitenansicht ein Fahrzeug 200 mit zwei beweglichen Fahrzeugelementen 201. Das bewegliche Fahrzeugelement 201 ist beispielsweise eine Fahrzeugtür 202, insbesondere eine Schiebetür 203 oder eine Schwenktür 204. Das Fahrzeugelement 201 umfasst das Griffmodul 100 sowohl zur Entriegelung eines Türschlosses und zum Öffnen des Fahrzeugelements 201 mittels des Betätigungssensors 100.5 und zum Stoppen und Wiederanfahren einer Bewegung des entriegelten Fahrzeugelements 201 mittels des Annäherungs- und/oder Gestensensors 100.4.

**Figur 14** zeigt das Griffmodul 100 in Draufsicht auf die Griffaußenseite 100.2. Das Griffmodul 100 ist als ein multifunktionaler Griff ausgebildet und umfasst den Annäherungs- und/oder Gestensensor 100.4, der auf der Griffaußenseite 100.2 in eine Blende 106, zum Beispiel eine Chrom- oder Kunststoffblende für das Griffmodul 100, integriert, insbesondere eingeformt, eingegossen und/oder angeordnet, ist.

Alternativ kann die erste Sensoreinheit 110.1 in das Betätigungselement 101 des Griffelements 100.1 und/oder dem Griffträger 105 integriert sein, beispielsweise in eine Wandung des Betätigungselements 101 eingespritzt ist.

Der Annäherungs- und/oder Gestensensor 100.4 ist beispielsweise als ein segmentierter kapazitiver Sensor mit mehreren kapazitiven Sensorsegmenten 100.41 ausgebildet, die auf der Griffaußenseite 100.2 des Griffmoduls 100, insbesondere in der Blende 106, angeordnet sind.

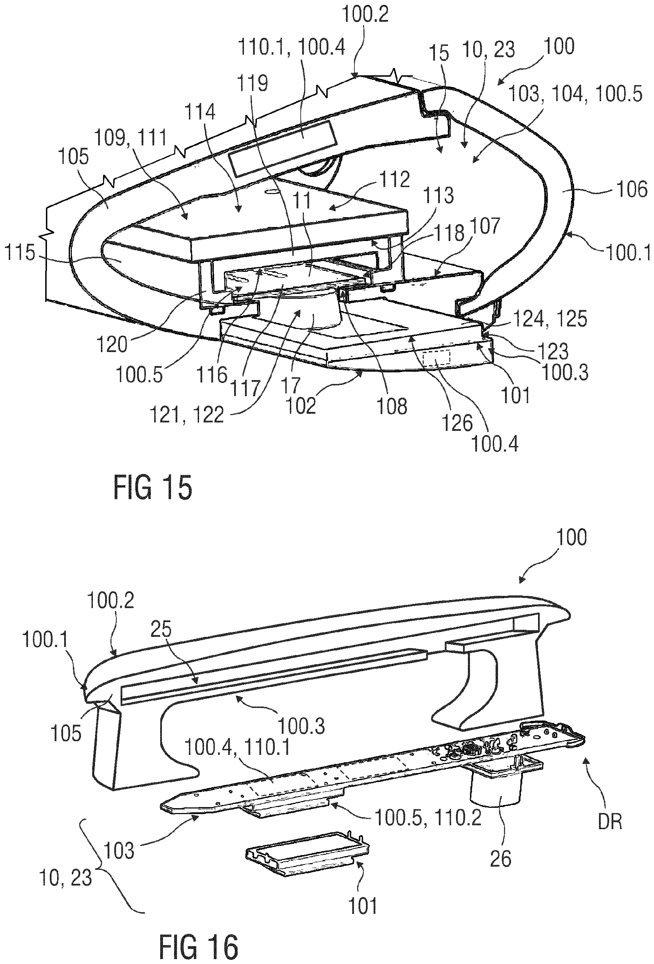

Die Sensorsegmente 100.41 sind signaltechnisch kombiniert und mit einer Auswerteelektronik einer in **Figur 15** dargestellten Elektronikeinheit 109 verbunden, so dass zum Beispiel eine berührungslose Wischbewegung im Bereich des äußeren Annäherungs- und/oder Gestensensors 100.4 aufgrund von kapazitiven Änderungen der Sensorsegmente 100.41 erkannt wird. Aufgrund des zeitlichen Versatzes der kapazitiven Änderungen der Sensorsegmente 100.41 kann eine Richtung der berührungslosen Wischbewegung detektiert werden und entsprechend ein Verfahrsignal für das bewegliche Fahrzeugelement 201 in die ermittelte Richtung ausgelöst werden, so dass das bewegliche Fahrzeugelement 201 in die ermittelte Richtung (Öffnungsrichtung AUF oder Schließrichtung ZU) bewegt wird.

Der Betätigungssensor 100.5 (gestrichelt dargestellt) ist auf der Griffinnenseite 100.3 und damit auf der Rückseite des Griffelements 100.1 im Bereich des Betätigungselements 101 angeordnet. Der Betätigungssensor 100.5 ermöglicht mehrere Funktionen, zum Beispiel eine Entriegelungsfunktion des Türschlosses und des beweglichen Fahrzeugelements 201 und/oder eine Stopp-/Wiederanfahrfunktion eines entriegelten und sich bewegenden Fahrzeugelements 201.

Ist das bewegliche Fahrzeugelement 201 beispielsweise in der geschlossenen und verriegelten Stellung, so wird durch punktuelles Berühren, insbesondere Drücken, der Betätigungsfläche 102 im Bereich des Betätigungssensors 100.5 in Richtung Griffinneres das Türschloss entriegelt und das bewegliche Fahrzeugelement 201 geöffnet. Mittels des inneren Betätigungssensors 100.5 kann dann bei einer Bewegung des Fahrzeugelements 201 durch erneutes punktuelles Berühren, insbesondere Drücken, der Betätigungsfläche 102 im Bereich des Betätigungssensors 100.5 die ausgelöste Bewegung des Fahrzeugelements 201 an jeder beliebigen Position gestoppt und auf Wunsch durch nochmalige Berührung, insbesondere Drücken, der Betätigungsfläche 102 wieder angefahren werden.

**Figur 15** zeigt schematisch in perspektivischer Teilansicht das Griffmodul 100 mit dem montierten Multi-Sensormodul 10 als integrierte Baueinheit 23 mit dem in der Griffinnenseite 100.3 angeordneten Betätigungssensor 100.5 als integriertes Modul 103 und dem auf der Griffaußenseite 100.2 angeordneten Annäherungs- und/oder Gestensensor 100.4.

**Figur 16** zeigt eine Explosionsdarstellung der Komponenten des Griffmoduls 100 mit dem Griffelement 100.1 und dem montierbaren Multi-Sensormodul 10 als integrierte Baueinheit 23 mit dem in der Griffinnenseite 100.3 anordbaren und auf der Elektronikeinheit 109 als integriertes Modul 103 angeordneten Betätigungssensor 100.5 und dem auf der Griffaußenseite 100.2 anordbaren Annäherungs- und/oder Gestensensor 100.4.

Der Betätigungssensor 100.5 ist als ein integriertes Modul 103 ausgebildet und bildet eine Entriegelungseinheit 104 für das bewegliche Fahrzeugelement 201.

Das Griffmodul 100 ist als ein Außengriffmodul ausgebildet und umfasst das Griffelement 100.1 mit dem Betätigungselement 101 mit der äußeren Betätigungsfläche 102, dem Griffträger 105 und der Blende 106.

An dem Griffmodul 100, insbesondere am Griffträger 105 und an der Blende 106 ist das Betätigungselement 101 gehalten. Alternativ kann das Betätigungselement 101 nur am Griffträger 105 oder nur an der Blende 106 gehalten sein.

Das Betätigungselement 101 bildet dabei die Griffinnenseite 100.3. Der Griffträger 105 und/oder die Blende 106 können bereichsweise oder vollständig die Griffaußenseite 100.2 bilden.

Der Griffträger 105 und die Blende 106 umgeben dabei zumindest teilweise das innen liegende Multi-Sensormodul 10, das als Ganzes als integrierte Baueinheit 23 in das Griffmodul 100 eingebaut und montiert werden kann. Dazu umfasst das Griffmodul 100 beispielsweise im Griffträger 105 eine Ausnehmung 25, in welche das Multi-Sensormodul 10 als vormontierte integrierte Baueinheit 23 einsteckbar oder einschiebbar ist und dort form- und/oder kraftschlüssig gehalten ist. Dabei sind beispielsweise die ersten und zweiten Sensoreinheiten 110.1, 110.2, die Elektronikeinheit 109, das Betätigungselement 101 und/oder optional ein Mikroschalter 26 auf der Elektronikeinheit 109 vormontiert und bilden im montierten Zustand die integrierte Baueinheit 23, die dann in die Ausnehmung 25, insbesondere einen Schlitz oder eine Öffnung, eingeführt wird und in der Ausnehmung 25 beispielsweise form- und/oder kraftschlüssig, insbesondere mittels Reibschluss oder rastend, gehalten ist.

Der Betätigungssensor 100.5 ist zur automatischen Entriegelung und zum automatischen Öffnen eines Türschlosses der zugehörigen Fahrzeugtür 202 vorgesehen. Der Betätigungssensor 100.5 kann als ein separates integriertes Modul 103 ausgebildet sein und auf der Elektronikeinheit 109 vormontiert sein. Auch kann das Betätigungselement 101 als eine separate Vormontageeinheit ausgebildet sein und parallel zu dem Betätigungssensor 100.5 und beabstandet von diesem auf der Elektronikeinheit 109 vormontiert sein.

Zusätzlich umfasst das Griffmodul 100 die Griffblende 106, zum Beispiel eine Chrom- oder Kunststoffblende.

Der Betätigungssensor 100.5 als integriertes Modul 103 kann als Ganzes in dem Griffmodul 100 verbaut werden. Bedingt durch die Ausbildung des Betätigungssensors 100.5 als ein integriertes Modul 103 und des Multi-Sensormoduls 10 als integrierte Baueinheit 23 entfallen aufwendige einzelne Montageschritte.

Darüber hinaus kann durch die Ausbildung des Griffmoduls 100 mit dem Betätigungselement 101 ein elektrisches Türschloss sicher durch Druckbetätigung ausgelöst werden, wobei die innen liegenden elektronischen Komponenten des Betätigungssensors 100.5 geschützt angeordnet sind. Hierzu ist der Betätigungssensor 100.5 beispielsweise durch Kapselung, insbesondere zusätzlich mittels eines Vergussmaterials 15, geschützt.

Im Detail umgeben der Griffträger 105, die Blende 106 und das Betätigungselement 101 den innen liegenden Betätigungssensor 100.5 kapselnd. Durch die Ausbildung des Betätigungssensors 100.5 als integriertes Bauteil 103 und die zusätzliche Kapselung dieses durch den Griffträger 105, die Blende 106 und das Betätigungselement 101 ist eine zusätzliche Dichtebene auf der Außenseite des Griffmoduls 100 gegeben, so dass der Betätigungs-, insbesondere ein Hubmechanismus, des Betätigungselements 101 ebenfalls abgedichtet ist.

Das integrierte Bauteil 103 ist im Griffträger 105 an einer Innenseite 107 des Griffträgers 105 im Bereich einer Durchgangsöffnung 108 und gegenüberliegend zum Betätigungselement 101 angeordnet und montiert. Dies ermöglicht einen kompakten Aufbau des Griffmoduls 100 und kleine Betätigungshübe.

Das Griffmodul 100 umfasst im Detail das Griffelement 100.1 und das Multi-Sensormodul 10, das aus dem im Bereich der Griffinnenseite 100.3 angeordneten Betätigungssensor 100.5 und dem im Bereich der Griffaußenseite 100.2 angeordneten Annäherungs- und/oder Gestensensor 100.4 gebildet ist.

Durch die Integration der Elektronikeinheit 109 in Kombination mit dem Betätigungssensor 100.5 und dem Annäherungs- und/oder Gestensensor 100.4 in das Multi-Sensormodul 10 und dieses wiederum in dem Griffmodul 100 kann das Griffmodul 100 zusätzlich zur Entriegelung des Schlosses weitere Funktionen, zum Beispiel weitere elektronische Griff-, Schloss- und/oder Türfunktionen, übernehmen und ausführen.

Die Elektronikeinheit 109 umfasst eine Leiterplatte 111 mit einer ersten Oberflächenseite 112 und einer zweiten Oberflächenseite 113. Auf der ersten Oberflächenseite 112 ist eine integrierte Schaltungsanordnung 114, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite 113 ist der Betätigungssensor 100.5 angeordnet.

Der Betätigungssensor 100.5 ist beispielsweise als ein Kraftsensor, insbesondere ein kraftgesteuerter kapazitiver Sensor, zum Entriegeln und Öffnen des Türschlosses und der Fahrzeugtür 201 ausgebildet.

Insbesondere ist der Betätigungssensor 100.5 als ein sogenanntes MOC-Modul ausgebildet (= metall-over-cap-Modul), bei welchem die innen liegenden metallischen Sensorkomponenten nach außen hin gekapselt sind.

Der Betätigungssensor 100.5 umfasst darüber hinaus ein Sensorgehäuse 115, das feste Sensorelement 116 und das bewegliche Sensorelement 117.

Das feste Sensorelement 116, insbesondere eine Metallschicht, zum Beispiel eine Kupferschicht, ist direkt auf der zweiten Oberflächenseite 113 der Leiterplatte 111 angeordnet. Das bewegliche Sensorelement 117 ist im Abstand zum festen Sensorelement 116 in einer Aufnahmeöffnung 118 des Sensorgehäuses 115 angeordnet. Das bewegliche Sensorelement 117 ist eine Metallfeder, insbesondere ein Metallblech. Das feste Sensorelement 116 und das bewegliche Sensorelement 117 bilden Elektroden des Betätigungssensors 100.5.

Der innenliegende Betätigungssensor 100.5 wird durch Kraft beaufschlagt, zum Beispiel durch eine Druckkraft an der Griffinnenseite 100.3. Übersteigt die Kraft einen vorgegebenen Schwellwert, wird dies als ein Öffnungswunsch identifiziert und das Türschloss sicher entriegelt. Die Auslösung der Entriegelung erfolgt zum Beispiel durch Drücken des Griffmoduls 100 an der Griffinnenseite 100.3 gegen die Betätigungsfläche 102 in Richtung der Fahrzeugkarosserie, so dass das Betätigungselement 101 ins Griffinnere gedrückt wird. Bei einem hinreichend großen Betätigungshub des Betätigungselements 101 in das Griffinnere nimmt das Betätigungselement 101 das bewegliche Sensorelement 117, insbesondere ein Federblech oder eine Metallfeder, mit und drückt dieses ebenfalls in das Griffinnere, wodurch der Abstand zum festen Sensorelement 116, insbesondere einer Metallschicht, zum Beispiel einer Kupferschicht auf der zweiten Oberflächenseite 113 der Leiterplatte 111, verändert wird und bei Überschreiten eines vorgegeben Schwellwertes ein Öffnungssignal erzeugt wird und beispielsweise das Türschloss entriegelt oder eine Türbewegung gestoppt wird.

Das Sensorgehäuse 115 und das bewegliche Sensorelement 117 kapseln dabei das innen liegende feste Sensorelement 116 nach außen hin ab. Das Sensorgehäuse 115 ist insbesondere ein Kunststoffgehäuse und kann an die Leiterplatte 111 angeformt, insbesondere angespritzt sein. Das Sensorgehäuse 115 kann als ein 2-Komponenten-Gehäuse ausgebildet sein. Beispielsweise kann das Sensorgehäuse 115 eine innen liegende weiche Gehäusewand 119 und eine diese umgebende äußere harte Gehäusewand 120 aufweisen.

Im eingebauten Zustand des integrierten Moduls 103 im Griffmodul 100 ist das bewegliche Sensorelement 117 im Bereich der Durchgangsöffnung 108 derart angeordnet, dass es die Durchgangsöffnung 108 von innen zumindest teilweise überdeckt.

Das Betätigungselement 101 ist derart im Bereich der Durchgangsöffnung 108 angeordnet, dass es die Durchgangsöffnung 108 von außen zumindest teilweise überdeckt. Insbesondere ragt das Betätigungselement 101 derart in die Durchgangsöffnung 108 zumindest bereichsweise hinein, dass es in einer unbetätigten Stellung, wie in **Figur 15** gezeigt, zum beweglichen Sensorelement 117 beabstandet angeordnet ist.

Dies ermöglicht einen kompakten Aufbau des Griffmoduls und kleine Betätigungshübe. Darüber hinaus sind die Betätigungskräfte einstellbar, insbesondere sind Schwellenwerte für den Betätigungshub, vorgebbar. Beispielsweise können Schwellenwerte für den Betätigungshub vorgegeben werden, so dass ein Entriegeln des Türschlosses nur ausgelöst wird, wenn der Betätigungshub den vorgegebenen Schwellenwert überschritten hat. Bei Unterschreiten eines Schwellenwertes für den Betätigungshub erfolgt hingegen keine Entriegelung des Türschlosses. Auch können die Schwellenwerte für den Betätigungshub in Abhängigkeit von erfassten Werten weiterer Parameter, wie zum Beispiel Luftfeuchtigkeit, Temperatur, Geschwindigkeit des Fahrzeugs, etc. variieren und somit entsprechend dynamisch angepasst werden. Hierzu umfasst die Elektronikeinheit 109 entsprechende Filter, Softwarelogiken und/oder Analysemodule. Darüber hinaus ermöglicht die Kapselung mittels des Schaummaterials 11 und die Abdichtung mittels der Abdichtungsstränge 22 Toleranzkompensationen, insbesondere die Kompensation von Fertigungstoleranzen zur Kalibrierung der Sensoreinheiten 110.1, 110.2.

Darüber hinaus kann das Betätigungselement 101 ein Druckübertragungselement 121 umfassen, dass von der äußeren, griffinnenseitigen Betätigungsfläche 102 nach innen in Richtung des Betätigungssensors 100.5 ragt. Beispielsweise umfasst das Betätigungselement 101 einen nach innen ragenden Druckstift 122, welcher bei Betätigung des Betätigungselements 101 in Druckrichtung DR und damit in Richtung des beweglichen Sensorelements 117 bewegbar ist.

Dabei ist das Betätigungselement 101 derart durch Druck betätigbar, dass es in Druckrichtung DR durch die Durchgangsöffnung 108 hindurch bis zum Sensoroberteil 117 bewegbar ist und dieses bei weiterer Druckbetätigung in Richtung des festen Sensorelements 116 bewegt wird. Hierdurch wird der Abstand zwischen dem beweglichen Sensorelement 117 und dem festen Sensorelement 116 reduziert, so dass sich ein zwischen diesen vorhandenes Messfeld des Betätigungssensors 100.5 ändert.

Zur Erfassung dieser Messfeldänderung ist der Betätigungssensor 100.5 als kapazitiver Drucksensor ausgebildet, wobei das feste Sensorelement 116 und das bewegliche Sensorelement 117 die Elektroden bilden, die mit einer elektronischen Schalteinheit der Elektronikeinheit 109 auf der Rückseite (= erste Oberflächenseite 112) der Leiterplatte 111 signaltechnisch gekoppelt sind. Wird mittels der elektronischen Schalteinheit eine entsprechend große Messfeldänderung aufgrund der Druckbetätigung erfasst, wird das Türschloss automatisch geöffnet.

Das bewegliche Sensorelement 117 ist hierzu beispielsweise als eine Federplatte oder ein Federblech ausgebildet.

Ferner weist das Betätigungselement 101 eine der äußeren Betätigungsfläche 102 gegenüberliegende Innenseite 123 auf, die mittels eines Verbindungselements 124 mit dem Griffträger 105 zumindest im Bereich der Durchgangsöffnung 108 abdichtend verbunden ist. Mit anderen Worten: Das Betätigungselement 101 ist mittels des Verbindungselements 124 mit dem Griffträger 105 verbunden, insbesondere verklebt.

Dabei kann das Verbindungselement 124 zusätzlich als ein Rückstellelement 125 ausgebildet sein, das bei einer Betätigung des Betätigungselements 101 von einer unbetätigten Position in eine betätigte Position dieses bei Nichtbetätigung zurück in die unbetätigte Position stellt.

Hierzu ist das Verbindungselement 124 beispielsweise als ein Kunststoffstrang, insbesondere als ein Gummi- oder Schaumstrang, ausgebildet. Insbesondere ist das Verbindungselement 124 aus einem Weichkomponentenmaterial, insbesondere aus einem Schaum-, Kunststoff- oder Gummimaterial gebildet. Beispielsweise ist das Verbindungselement 124 aus einem PUR-Schaum, insbesondere einen CeraPur-Schaum gebildet.

Das Verbindungselement 124 kann auf der dem Betätigungssensor 100.5 zugewandten Innenseite 123 des Betätigungselements 101 darüber hinaus einen im Randbereich der Durchgangsöffnung 108 angeordneten umlaufenden Dichtungsstrang 126 bilden.

Alternativ oder zusätzlich kann das Verbindungselement 124 das Betätigungselement 101 auf der dem Betätigungssensor 100.5 zugewandten Innenseite 123 randseitig umlaufen und gegen Feuchtigkeit und Verschmutzung abdichten.

Somit übernimmt das Verbindungselement 124 mehrere Funktionen: zumindest Abdichtung, Befestigung und Zurückstellung. Darüber hinaus kann das Verbindungselement 124 zur Dämpfung von Vibrationen dienen.

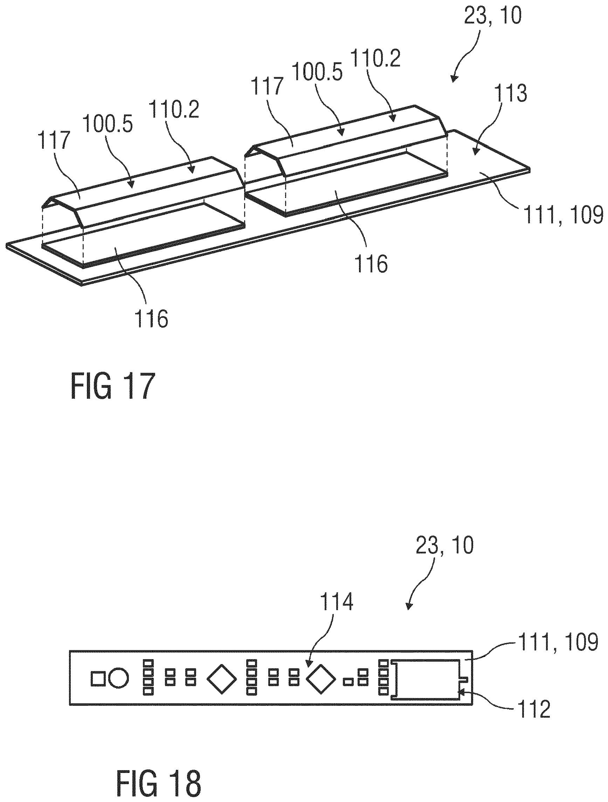

**Figuren 17, 18** zeigt schematisch eine Ober- und Unterseite der integrierten Baueinheit 23 für das Multi-Sensormodul 10, die ein separates Montagemodul bildet. Die integrierte Baueinheit 23 umfasst die Leiterplatte 111 mit der ersten Oberflächenseite 112 und der zweiten Oberflächenseite 113. Auf der ersten Oberflächenseite 112 ist die integrierte Schaltungsanordnung 114 der Elektronikeinheit 109, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite 113 ist der Betätigungssensor 100.5 angeordnet. Dabei kann dessen bewegliches Sensorelement 117 mittels Schaummaterial 11 gekapselt und als ein separates integriertes Bauteil 103 auf der Leiterplatte 111 vormontiert sein. Optional kann das feste Sensorelement 116 Teil der Leiterplatte 111 oder Teil des integrierten Bauteils 103 sein. Zusätzlich kann der Betätigungssensor 100.5 mit Vergussmaterial 15 versehen sein.

Zur besseren Übersichtlichkeit sind in dieser Darstellung die Anschlusselemente 12 des beweglichen Sensorelements 117 nicht dargestellt.

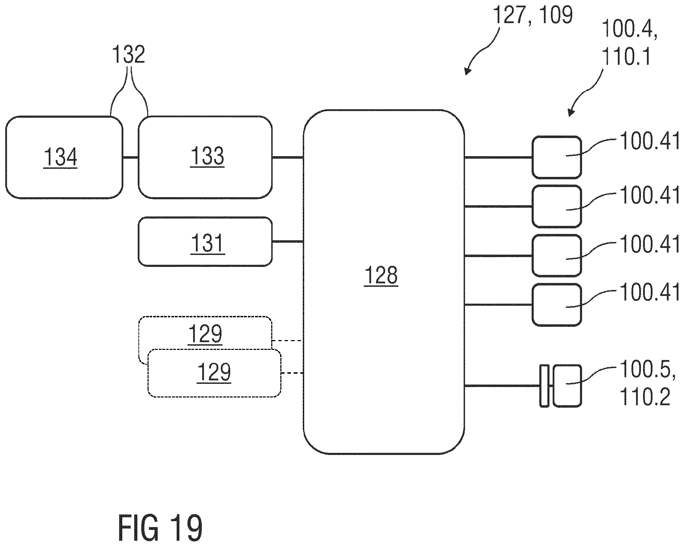

**Figur 19** zeigt schematisch in Blockdarstellung Komponenten einer elektronischen Schaltung 127 der Elektronikeinheit 109 für den Betätigungssensor 100.5 (= zweite Sensoreinheit 110.2) und den Annäherungs- und/oder Gestensensor 100.4 (= erste Sensoreinheit 110.1). Die elektronische Schaltung 127 ist Teil der integrierten Schaltungsanordnung 114 der Leiterplatte 111 und umfasst beispielsweise einen Mikrocontroller 128. Der Mikrocontroller 128 umfasst eine Softwarelogik, mittels welcher die von dem Betätigungssensor 100.5 und/oder dem Annäherungs- und/oder Gestensensor 100.4 erfasste Messfeldänderungen analysiert werden und entsprechende Auslösesignale, zum Beispiel zum Entriegeln und Öffnen des Türschlosses und/oder zum Stoppen oder Wiederanfahren des Fahrzeugelements 201, erzeugt werden.

Der Annäherungs- und/oder Gestensensor 100.4 umfasst beispielsweise als ein segmentierter kapazitiver Sensor mehrere kapazitive Sensorsegmente 100.41. Die Sensorsegmente 100.41 sind signaltechnisch kombiniert und mit dem Mikrocontroller 128 verbunden, so dass zum Beispiel eine berührungslose Wischbewegung im Bereich des äußeren Gestensensors 100.4 aufgrund von kapazitiven Änderungen der Sensorsegmente 100.41 erkannt wird. Aufgrund des zeitlichen Versatzes der kapazitiven Änderungen der Sensorsegmente 100.41 kann eine Richtung der berührungslosen Wischbewegung detektiert werden und entsprechend ein Verfahrsignal für das bewegliche Fahrzeugelement 201 in die ermittelte Richtung mittels der Logik des Mikrocontrollers 128 erzeugt ausgelöst werden und an eine Stelleinheit des Fahrzeugelements 201 über eine Eingangs-/Ausgangsschnittstelle 131 übertragen werden, so dass das bewegliche Fahrzeugelement 201 in die ermittelte Richtung bewegt wird.

Mittels des inneren Betätigungssensors 100.5 kann dann ein punktuelles Berühren der Betätigungsfläche 102 erfasst und mittels der Logik des Mikrocontrollers 128 als Stoppwunsch identifiziert werden, um ein Stoppsignal zu erzeugen und an die Stelleinheit des Fahrzeugelements 201 zu übertragen, wodurch die Bewegung des Fahrzeugelements 201, wie einer Tür, an jeder beliebigen Position gestoppt werden kann. Eine nochmalige Berührung, insbesondere Drücken, der Betätigungsfläche 102 des gestoppten Fahrzeugelements 201 wird von dem Betätigungssensor 100.5 erfasst und mittels der Logik des Mikrocontrollers 128 als ein Wiederanfahrwunsch detektiert, so dass der Mikrocontroller 128 ein weiteres Steuersignal für die Stelleinheit des Fahrzeugelements 201 erzeugt und an die Stelleinheit überträgt, so dass das Fahrzeugelement 201 wieder angefahren wird.

Darüber hinaus kann optional ein Verriegelungssensor 130 in dem Griffmodul 100 integriert sein, wobei der Mikrokontroller 128 anhand eines erfassten Verriegelungssignals des Verriegelungssensors 130 ein Verriegelungsbefehl für das Türschloss bei geschlossenem, aber noch nicht verriegelten Fahrzeugelement 201, insbesondere geschlossener und noch nicht verriegelter Tür, Front-/Motorhaube oder Heckklappe, erzeugt und an eine Stelleinheit für das Türschloss zur automatischen Verriegelung des Türschlosses übertragen wird.

Ferner kann die Softwarelogik des Mikrocontrollers 128 ausgebildet sein, dass bei Bewegung der entriegelten Fahrzeugtür 202 die Bewegung der Fahrzeugtür 202 an jeder Position gestoppt werden kann, wenn eine Messfeldänderung des Betätigungssensors 100.5 aufgrund eines erneuten Drückens des Betätigungselements 101 identifiziert wird.

Somit ermöglicht der Betätigungssensor 100.5 gekoppelt mit der integrierten Schaltungsanordnung 114 sowohl eine Entriegelung und damit ein Öffnen des Türschlosses durch Drücken des Betätigungselements 101 als auch ein Stoppen der sich bewegenden Fahrzeugtür 202 an jeder gewünschten Position durch erneutes Drücken des Betätigungselements 101.

Der Mikrocontroller 128 kann weitere Softwarefunktionen für das Türschloss, die Fahrzeugtür 202 und/oder das Griffmodul 100 umfassen. Hierzu ist der Mikrocontroller 128 beispielsweise über ein oder mehrere Kommunikationsschnittstellen 129, zum Beispiel eine LIN-Schnittstelle oder eine CAN-Schnittstelle, mit anderen Komponenten gekoppelt. Ferner können weitere, im Griffmodul 100 optional implementierte Sensoren, zum Beispiel weitere kapazitive Sensoren zur Annäherungserkennung, mit dem Mikrocontroller 128 signaltechnisch gekoppelt sein. Ferner kann der Mikrocontroller 128 über weitere Eingangs- und Ausgangsschnittstellen 131 mit anderen elektronischen Komponenten oder externen, mobilen Geräten, wie einem Mobiltelefon, signaltechnisch gekoppelt sein.

Darüber hinaus kann der Mikrocontroller 128 mit weiteren Softwaremodulen 132, zum Beispiel einem Spannungsregler 133 und/oder einer EMV-Schutzeinrichtung 134, signaltechnisch gekoppelt sein.

Im Mikrocontroller 128 können darüber hinaus zur Identifizierung einer Betätigung des Betätigungselements 101 Schwellwertmodule, Filtermodule, Regenmodule, Störungsmodule, Zeitmodule, Geschwindigkeitsmodule als Softwaremodule implementiert sein, welche beispielsweise in Abhängigkeit von Temperatur, Regen, EMV-Störungen, Betätigungsgeschwindigkeit und/oder Luftfeuchtigkeit Schwellwertanpassungen zur Identifizierung einer Messfeldänderung dynamisch vornimmt, um eine Druckbetätigung des Betätigungselements 101 sicher und schnell zu ermitteln.

So wird beispielsweise bei einem starken Signalhub in einer schnellen Auslösezeit keine relevante Betätigung und somit kein Auslösesignal zum Entriegeln des Türschlosses erzeugt.

Bei einer langsamen Betätigungsgeschwindigkeit wird ein Auslösesignal zum Entriegeln erzeugt, wenn die Signalhöhe den vorgegebenen Schwellwert überschreitet.

Beispielsweise wird als Schwellwert für einen Betätigungshub ein Wert von 2 mm vorgegeben.

### BEZUGSZEICHENLISTE

- 10: Multi-Sensormodul
- 11: Schaummaterial
- 12: Anschlusselement
- 13: Durchgangsöffnung
- 14: Basiselement
- 15: Vergussmaterial
- 16: Betätigungsstößel
- 17: Gegenstößel
- 18: Abstandselement
- 19: Abschirmung
- 20: Messfeld
- 21: Sensorgehäuse
- 22: Dichtungsstrang
- 23: integrierte Baueinheit
- 24: Anschlussfläche
- 25: Ausnehmung
- 26: Mikroschalter

- 100: Griffmodul
- 100.1: Griffelement
- 100.2: Griffaußenseite
- 100.3: Griffinnenseite
- 100.4: Annäherungs- und/oder Gestensensor
- 100.41: Sensorsegment
- 100.5: Betätigungssensor
- 100.6: Steckeranbindung
- 100.7: Antenne
- 101: Betätigungselement
- 102: Betätigungsfläche
- 103: integriertes Bauteil
- 104: Entriegelungseinheit
- 105: Griffträger
- 106: Blende
- 107: Innenseite
- 108: Durchgangsöffnung
- 109: Elektronikeinheit
- 110.1: erste Sensoreinheit
- 110.2: zweite Sensoreinheit
- 111: Leiterplatte
- 112: erste Oberflächenseite
- 113: zweite Oberflächenseite
- 114: integrierte Schaltungsanordnung
- 115: Sensorgehäuse
- 116: festes Sensorelement
- 117: bewegliches Sensorelement
- 118: Aufnahmeöffnung
- 119: weiche Gehäusewand
- 120: harte Gehäusewand
- 121: Druckübertragungselement
- 122: Druckstift
- 123: Innenseite
- 124: Verbindungselement
- 125: Rückstellelement
- 126: Dichtungsstrang
- 127: elektronische Schaltung
- 128: Mikrocontroller
- 129: Kommunikationsschnittstelle
- 130: Verriegelungssensor
- 131: Eingangs- und Ausgangsschnittstelle
- 132: Softwaremodul
- 133: Spannungsregler
- 134: EMV-Schutzeinrichtung
- 200: Fahrzeug
- 201: bewegliches Fahrzeugelement
- 202: Fahrzeugtür
- 203: Schiebetür
- 204: Schwenktür

- AUF: Öffnungsrichtung
- DR: Druckrichtung
- P1, P2: Pfeil
- SR: Schwenkrichtung
- ZU: Schließrichtung

## Patentansprüche

1. Multi-Sensormodul (10), insbesondere für einen Griff, umfassend zumindest:
- eine erste Sensoreinheit (110.1), die als ein Annäherungs- und/oder Gestensensor (100.4) ausgebildet ist,
- eine zweite Sensoreinheit (110.2), die als ein Betätigungssensor (100.5) ausgebildet ist, und
- eine Elektronikeinheit (109), die elektrisch mit den Sensoreinheiten (110.1, 110.2) zur Auslösung eines Signals verbunden ist,
wobei der Betätigungssensor (100.5) als ein zumindest bereichsweise mittels eines Schaummaterials (11) gekapseltes und integriertes Bauteil (103) ausgebildet und auf einer Seite der Elektronikeinheit (109) montierbar ist und wobei der Annäherungs- und/oder Gestensensor (100.4) segmentiert ausgebildet und auf einer gegenüberliegenden Seite der Elektronikeinheit (109) montierbar ist.

2. Multi-Sensormodul (10) nach Anspruch 1, wobei das gekapselte und integrierte Bauteil (103) eine Vormontageeinheit bildet, die in einem Vormontagezustand auf der Elektronikeinheit (109) montierbar ist.

3. Multi-Sensormodul (10) nach Anspruch 1 oder 2, wobei das Multi-Sensormodul (10) zusätzlich zumindest bereichsweise von einem Vergussmaterial (15) umgeben und als eine integrierte Baueinheit (23) ausgebildet ist.

4. Multi-Sensormodul (10) nach einem der vorhergehenden Ansprüche, wobei Anschlusselemente (12) des Betätigungssensors (100.5) aus dem Schaummaterial (11) herausragen und mit der Elektronikeinheit (109) verbindbar oder verbunden sind.

5. Multi-Sensormodul (10) nach einem der vorhergehenden Ansprüche, wobei der Betätigungssensor (100.5) ein bewegliches Sensorelement (117) und ein festes Sensorelement (116) umfasst, welches beabstandet und gegenüberliegend zu dem beweglichen Sensorelement (117) angeordnet ist,
wobei zumindest das bewegliche Sensorelement (117) mittels des Schaummaterials (11) zumindest bereichsweise separat gekapselt ist und das integrierte Bauteil (103) bildet, wobei Anschlusselemente (12) des beweglichen Sensorelements (117) aus dem Schaummaterial (11) herausragen und mit der Elektronikeinheit (109) verbindbar oder verbunden sind.

6. Multi-Sensormodul (10) nach einem der vorhergehenden Ansprüche,
wobei die Anschlusselemente (12) als Oberflächenanschlusselemente ausgebildet sind.

7. Multi-Sensormodul (10) nach einem der vorhergehenden Ansprüche,
wobei die erste Sensoreinheit (110.1) und/oder die zweite Sensoreinheit (110.2) jeweils zusätzlich von einem Vergussmaterial (15) zumindest bereichsweise umgeben sind bzw. ist.

8. Multi-Sensormodul (10) nach einem der vorhergehenden Ansprüche, wobei die erste Sensoreinheit (110.1) als ein kapazitiver Sensor ausgebildet ist.

9. Multi-Sensormodul (10) nach einem der vorhergehenden Ansprüche, wobei die zweite Sensoreinheit (110.2) als ein Kraftsensor, insbesondere ein kraftgesteuerter kapazitiver oder induktiver Sensor, zum Ausführen einer Schaltfunktion, wie zum Beispiel zum Entriegeln eines Türschlosses und Öffnen einer Tür, ausgebildet ist.

10. Multi-Sensormodul (10) nach einem der vorhergehenden Ansprüche,
wobei zur Betätigung des beweglichen Sensorelements (117) ein Betätigungselement (101), vorgesehen ist, das oberhalb und/oder unterhalb des beweglichen Sensorelements (117) angeordnet ist.

11. Multi-Sensormodul (10) nach Anspruch 10,
wobei das Betätigungselement (101) bereichsweise oder vollständig von dem Schaummaterial (11) gekapselt ist und Teil des integrierten Bauteils (103) ist.

12. Griffmodul (100), insbesondere ein Außengriffmodul für ein bewegliches Fahrzeugelement (201) eines Fahrzeugs (200), umfassend zumindest
- ein Griffelement (100.1) und
- ein Multi-Sensormodul (10) nach einem der vorhergehenden Ansprüche ausgebildet als integrierte Baueinheit (23), die als Montageeinheit am oder im Griffelement (100.1) montierbar ist.

13. Griffmodul nach Anspruch 12, wobei
- das Griffelement (100.1) eine Griffaußenseite (100.2) und eine Griffinnenseite (100.3) aufweist,
wobei die Baueinheit (23) derart in das Griffelement montierbar ist, dass der Annäherungs- und/oder Gestensensor (100.4) an oder in der Griffaußenseite (100.2) und der Betätigungssensor (100.5) an oder in der Griffinnenseite (100.3) angeordnet sind.

14. Griffmodul (100) nach Anspruch 12 oder 13, wobei das Griffelement (100.1) ein Betätigungselement (101) mit einer äußeren Betätigungsfläche (102) und einem Griffträger (105) umfasst, an welchem das Betätigungselement (101) gehalten ist, und wobei das Betätigungselement (101) an der Griffaußenseite (100.2) und der Griffträger (105) an der Griffinnenseite (100.3) angeordnet sind.

15. Griffmodul (100) nach einem der vorhergehenden Ansprüche 12 bis 14, wobei der Annäherungs- und/oder Gestensensor (100.4) als ein segmentierter kapazitiver Sensor mit mehreren kapazitiven Sensorsegmenten (100.41) ausgebildet ist, die im Betätigungselement (101) im Bereich der äußeren Betätigungsfläche (102) und/oder auf der der Griffaußenseite (100.2) zugewandten Oberflächenseite der Elektronikeinheit (109) angeordnet sind.

16. Bewegliches Fahrzeugelement (201) mit einem Griffmodul (100) nach einem der vorhergehenden Ansprüche 12 bis 15, in oder an welchem ein Multi-Sensormodul (10) nach einem der Ansprüche 1 bis 11 anordbar oder angeordnet ist.
